# EUROPEAN PATENT APPLICATION

(11) **EP 4 310 901 A2**
(43) Date of publication of application: **24.01.2024**
(21) Application number: 23175855.8
(22) Date of filing: 26.05.2023
(51) Int. Cl.: H01L 21/8234, H01L 27/088, H01L 29/06, H01L 29/66, H01L 29/775, H01L 29/786

(54) **SEMICONDUCTOR DEVICE**

(30) Priority: 18.07.2022 KR 20220088256
(71) Applicant: Samsung Electronics Co., Ltd., Suwon-si, Gyeonggi-do 16677 (KR)
(72) Inventor: CHO, Nam Kyu, 16677 Suwon-si (KR); KIM, Seok Hoon, 16677 Suwon-si (KR); KIM, Jung Taek, 16677 Suwon-si (KR); PARK, Pan Kwi, 16677 Suwon-si (KR); JEONG, Seo Jin, 16677 Suwon-si (KR)
(74) Representative: Marks & Clerk LLP

(57) **Abstract**

A semiconductor device includes: first and second channel structures spaced apart from each other in a first direction; and a source/drain pattern, between the first and second channel structures, including a first interface contacting the first channel structure and a second interface contacting the second channel structure, wherein, in a plan view, the source/drain pattern includes first and second side walls opposite to each other in a second direction, the first side wall includes a first sloped side wall, a second sloped side wall, and a first horizontal intersection at which the first and second sloped side walls meet, a width of the first interface is different from a width of the second interface, in the second direction, and a distance from the first interface to the first horizontal intersection is greater than a distance from the second interface to the first horizontal intersection, in the first direction.

## Description

### BACKGROUND

### 1. Field

The disclosure relates to a semiconductor device, and more specifically, to a semiconductor device including a field-effect-transistor and a method for manufacturing the same.

### 2. Description of the Related Art

With increasing demand for high device density of semiconductor devices, a field-effect-transistor having one or more active patterns as a structure surrounded by a gate structure has been proposed. The field-effect transistor may be a fin field-effect transistor (FinFET) having one or more fin structures, as a channel structure, protruded from a substrate and surrounded by a gate structure, or a nanosheet transistor having one or more sheet patterns or nanosheet layers, as a channel structure, stacked on a substrate in a vertical direction and surrounded by a gate structure. The nanosheet transistor is also referred to as a gate-all-around (GAA) transistor, a multi-bridge channel field-effect transistor (MBCFET ^{™}), or so on.

As the channel structure of the field-effect transistor is in three dimension (3D), scaling of a semiconductor device including the field-effect transistor is easily achieved. Further, in the field-effect transistor, a current control capability may be improved even without increasing a dimension of a gate structure. In addition, a short channel effect (SCE) in which a potential of a channel structure is affected by a source/drain voltage may be effectively suppressed in the field-effect transistor such as the nanosheet transistor.

### SUMMARY

Various embodiments of the disclosure provide a semiconductor device capable of improving device performance and reliability. However, the disclosure is not restricted to the embodiments set forth herein.

According to embodiments, there is provided a semiconductor device that may include: at least one first channel structure and at least one second channel structure spaced apart from each other in a first direction; and a source/drain pattern, between the first channel structure and the second channel structure, including a first interface contacting the first channel structure and a second interface contacting the second channel structure, wherein, in a plan view, the source/drain pattern includes a first side wall and a second side wall opposite to each other in a second direction, the first side wall of the source/drain pattern includes a first sloped side wall, a second sloped side wall, and a first horizontal intersection at which the first sloped side wall and the second sloped side wall meet, a width of the first interface is different from a width of the second interface, in the second direction, and a distance from the first interface to the first horizontal intersection is greater than a distance from the second interface to the first horizontal intersection, in the first direction.

According to embodiments, there is provided a semiconductor device that may include: at least one first channel structure and at least one second channel structure spaced apart from each other in a first direction; and a source/drain pattern, between the first channel structure and the second channel structure, including a first interface contacting the first channel structure and a second interface contacting the second channel structure, wherein, in a plan view, the source/drain pattern includes a first side wall and a second side wall which are opposite to each other in a second direction, the first side wall of the source/drain pattern includes a first sloped side wall, a second sloped side wall, and a first horizontal intersection at which the first sloped side wall and the second sloped side wall meet, the second side wall of the source/drain pattern includes a third sloped side wall, a fourth sloped side wall, and a second horizontal intersection at which the third sloped side wall and the fourth sloped side wall meet, a width of the first interface is smaller than a width of the second interface, in the second direction, and a distance from the first interface to the first horizontal intersection is different from a distance from the first interface to the second horizontal intersection, in the first direction.

At least some of the above and other features of the invention are set out in the claims.

### BRIEF DESCRIPTION OF DRAWINGS

The above and other aspects and features of the disclosure will become more apparent by describing in detail illustrative embodiments thereof with reference to the attached drawings, in which:
FIG. 1 is a layout diagram for explaining a semiconductor device according to some embodiments;
FIG. 2 is an example cross-sectional view taken along A-A of FIG. 1;
FIGS. 3 and 4 are cross-sectional views taken along B-B and C-C of FIG. 1;
FIGS. 5 to 7 are cross-sectional views taken along D-D, E-E and F-F of FIG. 1;
FIG. 8 is a plan view taken along G-G of FIG. 2 and viewed from above;
FIGS. 9 to 11 are enlarged views of a region P, a region Q and a region R of FIG. 8, respectively;
FIGS. 12 to 14 are diagrams for explaining a semiconductor device according to some embodiments;
FIG. 15 is a diagram for explaining a semiconductor device according to some embodiments;
FIGS. 16 and 17 are diagrams for explaining a semiconductor device according to some embodiments;
FIG. 18 is a layout diagram for explaining a semiconductor device according to some embodiments;
FIG. 19 is an example cross-sectional view taken along H-H of FIG. 18;
FIG. 20 is a plan view taken along G-G of FIG. 2 and viewed from above;
FIG. 21 is a plan view taken along J-J of FIG. 19 and viewed from above;
FIG. 22 is a layout diagram for explaining a semiconductor device according to some embodiments.

### DETAILED DESCRIPTION

The embodiments described herein are example embodiments, and thus, the disclosure is not limited thereto and may be realized in various other forms. Each of the embodiments provided in the above description is not excluded from being associated with one or more features of another example or another embodiment also provided herein or not provided herein but consistent with the disclosure. For example, even if matters described in a specific example or embodiment are not described in a different example or embodiment, the matters may be understood as being related to or combinable with the different example or embodiment, unless otherwise mentioned in descriptions thereof. In addition, it should be understood that all descriptions of principles, aspects, examples, and specific embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

As used herein, expressions such as "at least one of" when preceding a list of elements, modify the entire list of elements and do not modify the individual elements of the list. For example, the expression, "at least one of a, b, and c" should be understood as including only a, only b, only c, both a and b, both a and c, both b and c, or all of a, b, and c.

A semiconductor device according to some embodiments disclosed herein may include a field-effect transistor (FET), a three-dimensional (3D) transistor, or a two-dimensional material-based transistor (2D material-based FET), and a heterogeneous transistor structure thereof. Further, the semiconductor device according to some embodiments may include a bipolar junction transistor, a laterally diffused metal oxide semiconductor (LDMOS), or the like.

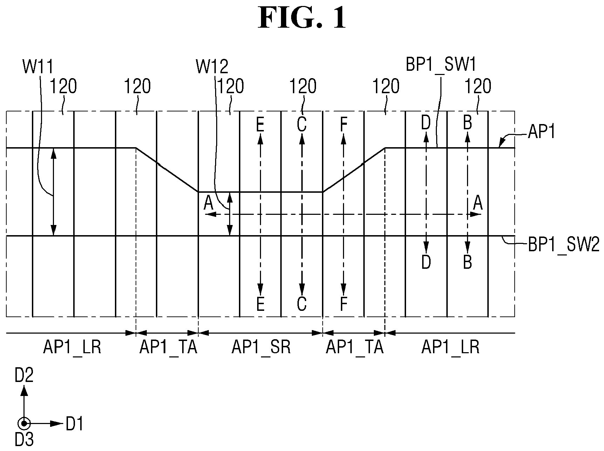

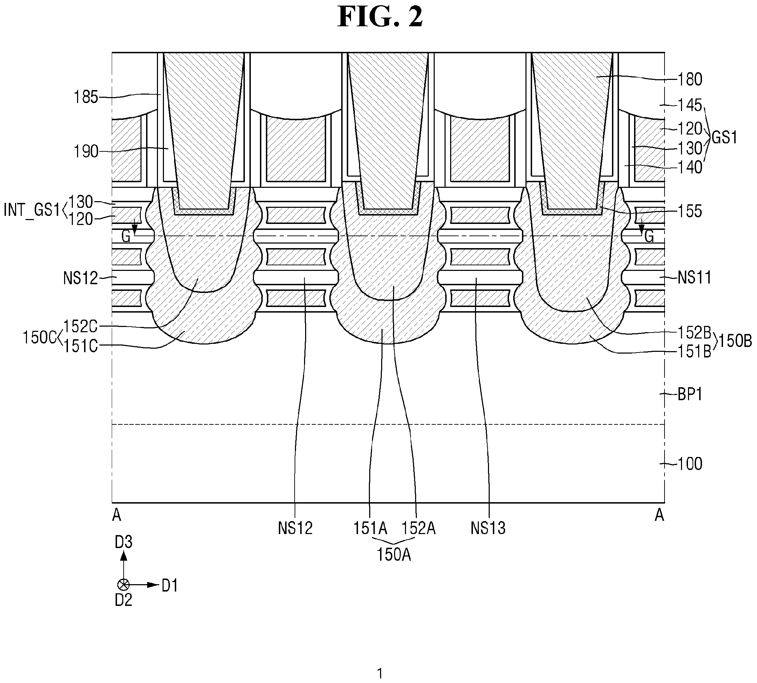

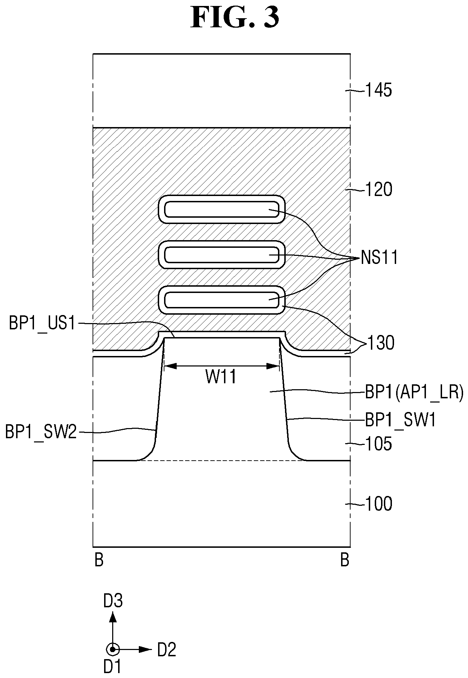

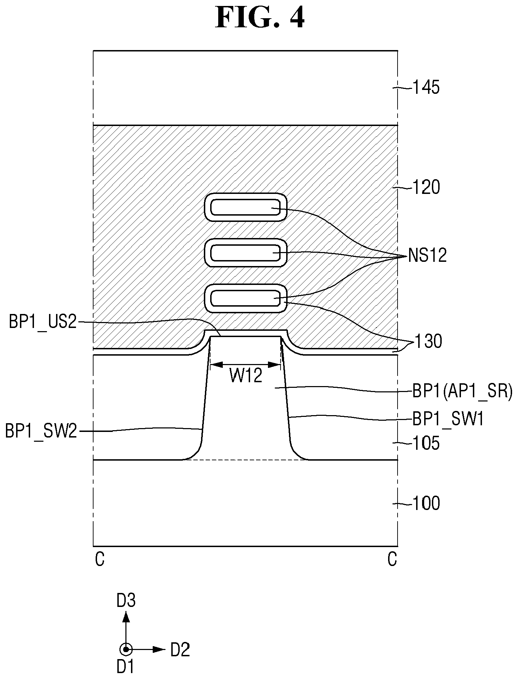

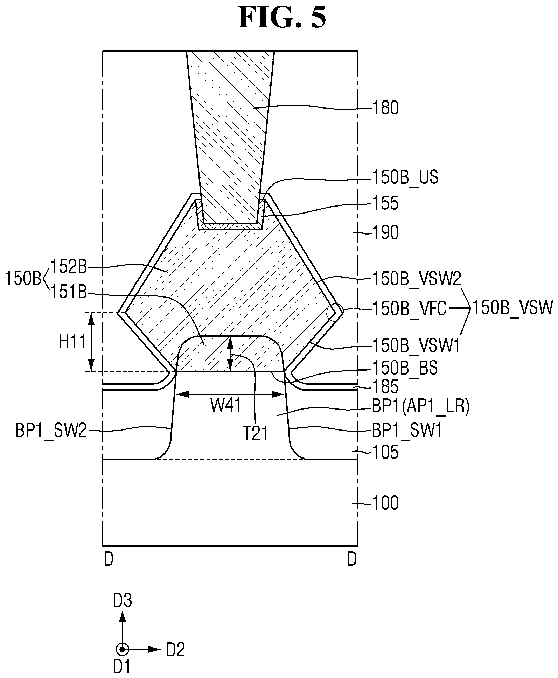

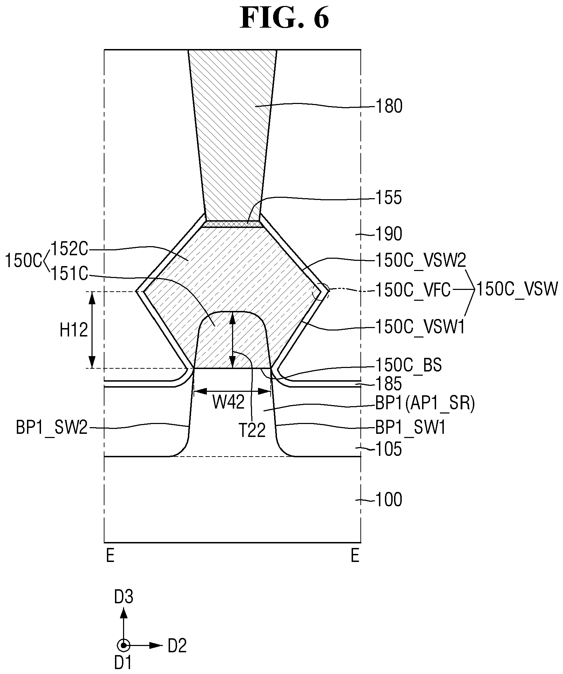

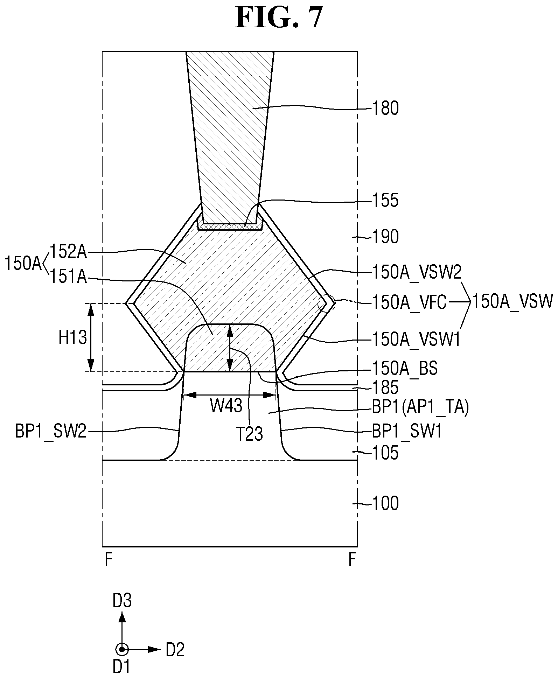

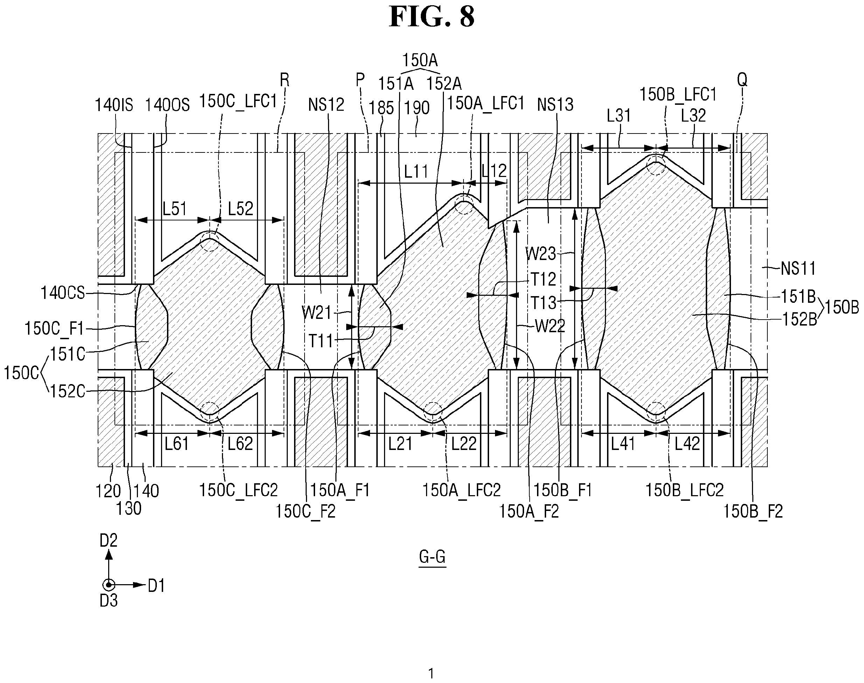

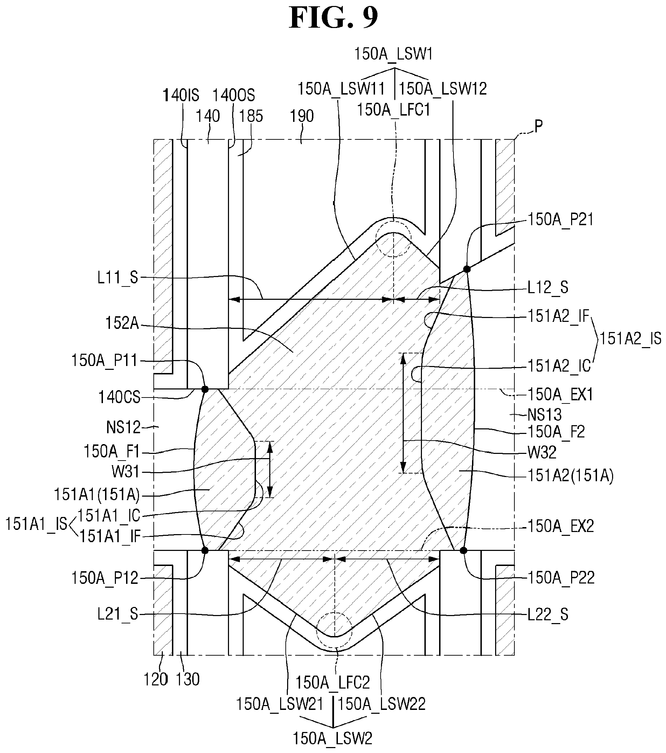

FIG. 1 is a layout diagram for explaining a semiconductor device according to some embodiments. FIG. 2 is an example cross-sectional view taken along a line A-A shown in FIG. 1. FIGS. 3 and 4 are cross-sectional views taken along lines B-B and C-C shown in FIG. 1. FIGS. 5 to 7 are cross-sectional views taken along lines D-D, E-E and F-F shown in FIG. 1. FIG. 8 is a plan view taken along a line G-G shown in FIG. 2 and viewed from above. FIGS. 9 to 11 are enlarged views of a region P, a region Q and a region R shown in FIG. 8, respectively.

Although FIGS. 5 to 7 are explained as cross-sectional views in which different portions of one active pattern are cut, the disclosure is not limited thereto. That is, cross-sectional views of a plurality of active patterns spaced apart from each other and having different widths may be similar to FIGS. 5 to 7.

Although FIG. 8 is described herebelow as a plan view related to FIG. 2, this is only for convenience of explanation and is not limited thereto. That is, when a semiconductor device having a layout as shown in FIG. 1 is horizontally cut at a specific height and viewed from above, a plan view such as FIG. 8 may be seen regardless of FIG. 2. Therefore, in the semiconductor device according to some embodiments, FIG. 8 does not need to be construed as being limited to being associated with FIG. 2.

Referring to FIGS. 1 to 11, the semiconductor device according to some embodiments may include a first active pattern AP1, a plurality of first gate electrodes 120, a first source/drain pattern 150A, a second source/drain pattern 150B, and a third source/drain pattern 150C.

The substrate 100 may be a bulk silicon or a silicon-on-insulator (SOI). In contrast, the substrate 100 may be a silicon substrate, or may include, but not limited to, other materials, for example, silicon germanium, silicon germanium on insulator (SGOI), indium antimonide, lead tellurium compounds, indium arsenic, indium phosphate, gallium arsenide or antimonide gallium.

The first active pattern AP1 may be disposed on the substrate 100. The first active pattern AP1 may extend long in a first direction D1. For example, the first active pattern AP1 may be disposed in a region in which one or more p-type metal-oxide-semiconductor field-effect transistors (PMOSs) are formed.

The first active pattern AP1 may include at least one first extended region AP1_LR, at least one first reduced region AP1_SR, and a first tapered region AP1_TA. The first tapered region AP1_TA may be disposed between the first extended region AP1_LR and the first reduced region AP1_SR. The first tapered region AP1_TA may connect the first extended region AP1_LR and the first reduced region AP1_SR.

In the following description, a width of the first active pattern AP1 in a second direction D2, perpendicular to the first direction D1 according to an embodiment, may be a width of an upper surface of a first lower pattern BP1, which will be described later. For example, the width of the first active pattern AP1 in the second direction D2 may be a width of the upper surface of the first lower pattern BP1 in a portion that overlaps the first gate electrode 120 in a third direction D3, perpendicular to the first and second directions D1 and D2 according to an embodiment.

Here, the first direction D1 and the second direction D may be a channellength direction and a channel-width direction, respectively, while a plurality of sheet patterns described herein are a channel or a channel structure of a transistor formed of source/drain regions and a gate structure surrounding the sheet patterns.

A width W11 of the first extended region AP1_LR in the second direction D2 may be a width of an upper surface BP1_US1 of the first lower pattern BP1 in the first extended region AP1_LR. A width W12 of the first reduced region AP1_SR in the second direction D2 may be a width of an upper surface BP1_US2 of the first lower pattern BP1 in the first reduced region AP1_SR.

The width W11 of the first extended region AP1_LR may be greater than the width W12 of the first reduced region AP1_SR. The width W11 of the first extended region AP1_LR and the width W12 of the first reduced region AP1_SR may be constant in the first direction D1. A width of the first tapered region AP1_TA in the second direction D2 may not be constant and decrease as it goes away from the first extended region AP1_LR in the first direction D1. The width of the first tapered region AP1_TA in the second direction D2 may vary from the first extended region AP1_LR to the first reduced region AP1_SR in the first direction D1.

Also, a side wall of the first active pattern AP1 may be a side wall of the first lower pattern BP1. The first lower pattern BP1 may include a first side wall BP1_SW1 and a second side wall BP1_SW2 that are opposite to each other in the second direction D2.The first side wall BP1_SW1 of the first lower pattern BP1 may be a first side wall of the first active pattern AP1. The second side wall BP1_SW2 of the first lower pattern BP1 may be a second side wall of the first active pattern AP1.

As shown in FIG. 1, which is a plan view, the first side wall BP1_SW1 of the first lower pattern BP1 may extend in the first direction D1, and have an uneven shape. The second side wall BP1_SW2 of the first lower pattern BP1 may extend in the first direction D1 and have a straight line shape.

In the semiconductor device according to some embodiments, in the plan view, the second side wall BP1_SW2 in the first extended region AP1_LR is aligned linearly with the second side wall BP1_SW2 in the first reduced region AP1_SR along the first direction D1. The first side wall BP1_SW1 in the first extended region AP1_LR is not aligned linearly with the first side wall BP1_SW1 in the first reduced region AP1_SR along the first direction D1.

The first active pattern AP1 may include the first lower pattern BP1, at least one set of first sheet patterns NS11, at least one set of second sheet patterns NS12, and at least one set of third sheet patterns NS13. These sheet patterns NS11, NS12 and NS13 may be formed by being vertically stacked with a gate structure (e.g., an inner gate structure INT_GS1 to be described later) therebetween.

The first lower pattern BP1 may protrude from the substrate 100. The first lower pattern BP1 may extend long in the first direction D1.

The first sheet patterns NS11 may be included in the first extended region AP1_LR. The first sheet patterns NS11 may be disposed on the upper surface BP1_US1 of the first lower pattern BP1 in the first extended region AP1_LR.

The first sheet pattern NS11 may include a first side wall and a second side wall opposite to each other in the first direction D1. In the plan view, a width of the first side wall of the first sheet pattern NS11 in the second direction D2 may be equal to a width of the second side wall of the first sheet pattern NS11 in the second direction D2. The first sheet pattern NS11 may include third and fourth side walls opposite to each other in the second direction D2. In the plan view, the third side wall of the first sheet pattern NS11 and the fourth side wall of the first sheet pattern NS11 may be substantially parallel to each other.

The second sheet patterns NS12 may be included in the first reduced region AP1_SR. The plurality of second sheet patterns NS12 may be disposed on the upper surface BP1_US2 of the first lower pattern BP1 in the first reduced region AP1_SR.

The second sheet pattern NS12 may include a first side wall and a second side wall opposite to each other in the first direction D1. In the plan view, a width of the first side wall of the second sheet pattern NS12 in the second direction D2 may be equal to a width of the second side wall of the second sheet pattern NS12 in the second direction D2. The second sheet pattern NS12 may include third and fourth side walls opposite to each other in the second direction D2. In the plan view, the third side wall of the second sheet pattern NS12 and the fourth side wall of the second sheet pattern NS12 may be substantially parallel to each other.

A part of a set of third sheet patterns NS13 may be included in the first extended region AP 1 LR, and the rest of the plurality of third sheet patterns NS13 may be included in the first tapered region AP1_TA. In other words, the plurality of third sheet patterns NS13 may be disposed at a boundary portion between the first extended region AP1_LR and the first tapered region AP1_TA. Although not shown, another set of third sheet patterns NS13 may be disposed at the boundary portion between the first reduced region AP1_SR and the first tapered region AP1_TA.

In other words, a set of third sheet patterns NS13 may be disposed over the first extended region AP1_LR and the first tapered region AP1_TA. Alternatively or additionally, although not shown, another set of third sheet patterns NS13 may be disposed over the first reduced region AP1_SR and the first tapered region AP1_TA.

The third sheet pattern NS13 may include a first side wall and a second side wall opposite to each other in the first direction D1. In the plan view, a width of the first side wall of the third sheet pattern NS13 in the second direction D2 may be different from a width of the second side wall of the third sheet pattern NS13 in the second direction D2. The third sheet pattern NS13 may include a third side wall and a fourth side wall opposite to each other in the second direction D2. In the plan view, a distance between the third side wall of the third sheet pattern NS13 and the fourth side wall of the third sheet pattern NS13 in the second direction D2 may change depending on a position where the distance is measured.

The first sheet patterns NS11, the second sheet patterns NS12, and the third sheet patterns NS13 may be spaced apart from the first lower pattern BP1 in the third direction D3. The first sheet patterns NS11 may be spaced apart from each other in the third direction D3. The second sheet patterns NS12 may be spaced apart from each other in the third direction D3. The third sheet patterns NS13 may be spaced apart from each other in the third direction D3. The third direction D3 may be a direction intersecting the first direction D1 and the second direction D2, according to an embodiment. For example, the third direction D3 may be a thickness direction of the substrate 100. The first direction D1 may be a direction intersecting the second direction D2, according to an embodiment.

The first sheet patterns NS11 may be spaced apart from the second sheet patterns NS12 and the third sheet patterns NS13 in the first direction D1. The second sheet patterns NS12 may be spaced apart from the third sheet pattern NS13 in the first direction D1.

Although three first sheet patterns NS11, three second sheet patterns NS12, and three third sheet patterns NS13 are shown as being disposed in the third direction D3, this is only for convenience of explanation, and the number of each of the sets of the first to third sheet patterns NS11, NS12 and NS13 is not limited thereto, and may be more or less than three.

The first lower pattern BP1 may be formed by etching a part of the substrate 100, or may include an epitaxial layer grown from the substrate 100. The first lower pattern BP1 may include silicon or germanium, which is an elemental semiconductor material. Also, the first lower pattern BP1 may include a compound semiconductor, and may include, for example, a group IV-IV compound semiconductor or a group III-V compound semiconductor.

The group IV-IV compound semiconductor may include, for example, a binary compound or a ternary compound including at least two or more of carbon (C), silicon (Si), germanium (Ge), and tin (Sn), or a compound obtained by doping these elements with a group IV element.

The group III-V compound semiconductor may be, for example, at least one of a binary compound, a ternary compound or a quaternary compound formed by combining at least one of aluminum (Al), gallium (Ga) and indium (In) as a group III element with one of phosphorus (P), arsenic (As) and antimony (Sb) as a group V element.

The first sheet pattern NS11, the second sheet pattern NS12 and the third sheet pattern NS13 may each include one of silicon and germanium which is an elemental semiconductor material, a group IV-IV compound semiconductor, or a group III-V compound semiconductor.

The first sheet pattern NS11, the second sheet pattern NS12 and the third sheet pattern NS13 may each include the same material. The first sheet pattern NS11, the second sheet pattern NS12, and the third sheet pattern NS13 may include the same material as the first lower pattern BP1, or may include a different material from the first lower pattern BP1.

In the semiconductor device according to some embodiments, the first lower pattern BP1 may be a silicon lower pattern including silicon, and the first sheet pattern NS11, the second sheet pattern NS12 and the third sheet pattern NS13 may each be a silicon sheet pattern including silicon.

In FIGS. 3 and 4, the width of the first sheet pattern NS 11 in the second direction D2 and the width of the second sheet pattern NS12 in the second direction D2 may increase or decrease in proportion to the width of the first lower pattern BP1 in the second direction D2. The first sheet pattern NS11 will be described as an example. Although the first sheet patterns NS11 stacked in the third direction D3 are shown as having an equal width in the second direction D2, this is only for convenience of explanation, and the disclosure is not limited thereto. Unlike the shown example, the width in the second direction D2 of the first sheet patterns NS11 stacked in the third direction D3 may decrease, as it goes away from the first lower pattern BP1.

A field insulating film 105 may be formed on the substrate 100. The field insulating film 105 may be disposed on the first side wall BP1_SW1 of the first lower pattern and the second side wall BP1_SW2 of the first lower side wall. The field insulating film 105 is not disposed on the upper surfaces BP1_US1 and BP1_US2 of the first lower pattern.

As an example, the field insulating film 105 may entirely cover the first side wall BP1_SW1 of the first lower pattern BP1 and the second side wall BP1_SW2 of the first lower side wall. Unlike the shown example, the field insulating film 105 may partially cover at least one of the first side wall BP1_SW1 of the first lower pattern BP1 and the second side wall BP1_SW2 of the first lower pattern BP1.

The first sheet pattern NS11, the second sheet pattern NS12, and the third sheet pattern NS13 may be disposed to be higher than an upper surface of the field insulating film 105. The field insulating film 105 may include, for example, an oxide film, a nitride film, an oxynitride film or a combination thereof. Although the field insulating film 105 is shown as a single film, this is only for convenience of explanation, and the disclosure is not limited thereto.

A plurality of first gate structures GS1 may be disposed on the substrate 100. Each first gate structure GS1 may extend in the second direction D2. The first gate structures GS1 may be spaced apart in the first direction D1. The first gate structures GS1 may be adjacent to each other in the first direction D1. For example, the first gate structures GS1 may be disposed on both sides of the source/drain patterns 150A, 150B, and 150C in the first direction D1.

The first gate structure GS1 may be disposed on the first active pattern AP1. The first gate structure GS1 may intersect the first active pattern AP1. The first gate structure GS1 may intersect the first lower pattern BP1. The first gate structure GS1 may surround each of the sheet patterns NS11, NS12, and NS13. The first gate structure GS1 may include a first gate electrode 120, a first gate insulating film 130, a first gate spacer 140, and a first gate capping pattern 145.

The first gate structure GS1 may include a first inner gate structure INT_GS1 disposed between the sheet patterns NS11, between the sheet patterns NS12, and between the sheet patterns NS13 adjacent to each other in the third direction D3. The first inner gate structure INT_GS1 is also disposed between the first lower pattern BP1 and each of the sets of the sheet patterns NS11, NS12 and NS13.

The first inner gate structure INT_GS1 may contact the upper surface of the first lower pattern BP1, the upper surfaces of the sheet patterns NS11, NS12 and NS13, and the lower surfaces of the sheet patterns NS11, NS12 and NS13. The first inner gate structure INT_GS1 may contact the source/drain patterns 150A, 150B, and 150C, which will be described later.

The first inner gate structure INT _GS 1 may include the first gate electrode 120 and the first gate insulating film 130 disposed between adjacent sheet patterns NS11, between adjacent sheet patterns NS12 and between adjacent sheet patterns NS13. The first inner gate structure INT_GS1 may include the first gate electrode 120 and the first gate insulating film 130 disposed between the first lower pattern BP1 and each of the sets of the sheet patterns NS11, NS12 and NS13.

In FIG. 2, although each first inner gate structure INT_GS1 disposed in the third direction D3 is shown to have an equal width in the first direction D1, the disclosure is not limited thereto. The first inner gate structures INT_GS1 disposed in the third direction D3 may have unequal widths in the first direction D1, according to an embodiment. A width of the first inner gate structure INT_GS1 may be measured between an upper surface of a sheet pattern NS11, NS12, or NS13 and a lower surface of another sheet pattern NS11, NS12, or NS13 that face each other in the third direction D3.

For reference, FIG. 8 shows a plan view at the sheet patterns NS11, NS12, and NS13 at a level disposed near a center in the third direction D3. Although not shown, when a portion in which a first contact plug 180 is formed is excluded, a plan view at the sheet patterns NS11, NS12, and NS13 at another level may be similar to FIG. 8. Although not shown, when the sheet patterns NS11, NS12, and NS13 are excluded, a plan view at a level of the first inner gate structure INT_GS1 disposed between the sheet patterns NS11, NS12, or NS13 adjacent to each other in the third direction D3 may be inferred using FIG. 8.

The first gate electrode 120 may be disposed on the first lower pattern BP1. The first gate electrode 120 may intersect the first lower pattern BP1. The first gate electrode 120 may surround the sheet patterns NS11, NS12, and NS13.

A part of the first gate electrode 120 may be disposed over the first extended region AP1_LR and the first tapered region AP1_TA. Alternatively, although not shown, a part of the first gate electrode 120 may be disposed over the first reduced region AP1_SR and the first tapered region AP1_TA.

Unlike the shown example, the first gate electrode 120 may not be disposed to overlap the first tapered region AP1_TA in the third direction D3.

The first gate electrode 120 may include at least one of metal, metal alloy, conductive metal nitride, conductive metal carbide, conductive metal carbonitride, metal silicide, doped semiconductor material, conductive metal oxide and conductive metal oxynitride. The first gate electrode 120 may include, for example, but not limited to, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and a combination thereof. The conductive metal oxide and the conductive metal oxynitride may include, but not limited to, an oxidized form of the above-mentioned materials.

The first gate electrode 120 may be disposed on both sides of source/drain patterns 150A, 150B and 150C to be described later. The first gate structure GS1 may be disposed on both sides of the source/drain patterns 150A, 150B and 150C in the first direction D1.

As an example, both the first gate electrodes 120 disposed on both sides of the source/drain patterns 150A, 150B and 150C may be normal gate electrodes functioning as a gate of a transistor. As another example, the first gate electrode 120 disposed on one side of the source/drain patterns 150A, 150B and 150C may function as a gate of a transistor, but the first gate electrode 120 disposed on the other side of the source/drain patterns 150A, 150B and 150C may be a dummy gate electrode.

The first gate insulating film 130 may extend along the upper surface of the field insulating film 105 and the upper surfaces BP1_US1 and BP1_US2 of the first lower pattern BP1. The first gate insulating film 130 may surround the sheet patterns NS11, NS12, and NS13. The first gate insulating film 130 may be disposed along a periphery of the sheet patterns NS11, NS12, and NS13. The first gate electrode 120 may be disposed on the first gate insulating film 130. The first gate insulating film 130 may be disposed between the first gate electrode 120 and each of the sheet patterns NS11, NS12, and NS13.

The first gate insulating film 130 may include silicon oxide, silicon-germanium oxide, germanium oxide, silicon oxynitride, silicon nitride or a high dielectric constant material having a higher dielectric constant than silicon oxide. The high dielectric constant material may include, for example, one or more of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide or lead zinc niobate.

Although the first gate insulating film 130 is shown as being a single film, this is only for convenience of explanation, and the disclosure is not limited thereto. The first gate insulating film 130 may include a plurality of films. The first gate insulating film 130 may include an interfacial layer disposed between the first gate electrode 120 and each of the sheet patterns NS11, NS12, and NS13, and a high dielectric constant film.

The semiconductor device according to some embodiments may include a negative capacitance (NC) field-effect transistor (FET) that uses a negative capacitor. For example, the first gate insulating film 130 may include a ferroelectric material film having ferroelectric properties, and a paraelectric material film having paraelectric properties.

The ferroelectric material film may have a negative capacitance, and the paraelectric material film may have a positive capacitance. For example, if two or more capacitors are connected in series and a capacitance of each capacitor has a positive value, overall capacitances decrease from the capacitance of each of the individual capacitors. On the other hand, if at least one of the capacitances of two or more capacitors connected in series has a negative value, the overall capacitances may be greater than an absolute value of each of the individual capacitances, while having a positive value.

When the ferroelectric material film having the negative capacitance and the paraelectric material film having the positive capacitance are connected in series, the overall capacitance values of the ferroelectric material film and the paraelectric material film connected in series may increase. Based on the increased overall capacitance value, a transistor including the ferroelectric material film may have a subthreshold swing (SS) below 60 mV/decade at room temperature.

The ferroelectric material film may have ferroelectric properties. The ferroelectric material film may include, for example, at least one of hafnium oxide, hafnium zirconium oxide, barium strontium titanium oxide, barium titanium oxide, and lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may further include a doped dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). A type of dopant included in the ferroelectric material film may vary, depending at which type of ferroelectric material is included in the ferroelectric material film.

When the ferroelectric material film may include hafnium oxide, the dopant included in the ferroelectric material film may include, for example, at least one of gadolinium (Gd), silicon (Si), zirconium (Zr), aluminum (Al), and yttrium (Y).

When the dopant is aluminum (Al), the ferroelectric material film may include 3 to 8 at% (atomic %) aluminum. Here, a ratio of the dopant may be a ratio of aluminum to the sum of hafnium and aluminum.

When the dopant is silicon (Si), the ferroelectric material film may include 2 to 10 at% silicon. When the dopant is yttrium (Y), the ferroelectric material film may include 2 to 10 at% yttrium. When the dopant is gadolinium (Gd), the ferroelectric material film may include 1 to 7 at% gadolinium. When the dopant is zirconium (Zr), the ferroelectric material film may include 50 to 80 at% zirconium.

The paraelectric material film may have the paraelectric properties. The paraelectric material film may include at least one of, for example, silicon oxide and metal oxide having a high dielectric constant. The metal oxide included in the paraelectric material film may include, for example, but not limited to, at least one of hafnium oxide, zirconium oxide, and aluminum oxide.

The ferroelectric material film and the paraelectric material film may include a same material. The ferroelectric material film has the ferroelectric properties, but the paraelectric material film may not have the ferroelectric properties. For example, when the ferroelectric material film and the paraelectric material film include hafnium oxide, a crystal structure of hafnium oxide included in the ferroelectric material film differs from a crystal structure of hafnium oxide included in the paraelectric material film.

The ferroelectric material film may have a thickness having the ferroelectric properties. A thickness of the ferroelectric material film may be, for example, but not limited to, 0.5 to 10 nm. Since a critical thickness that exhibits the ferroelectric properties may vary for each ferroelectric material, the thickness of the ferroelectric material film may vary depending on the ferroelectric material.

As an example, the first gate insulating film 130 may include one ferroelectric material film. As another example, the first gate insulating film 130 may each include a plurality of ferroelectric material films spaced apart from each other. The first gate insulating film 130 may have a stacked film structure in which the plurality of ferroelectric material films and the plurality of paraelectric material films are alternately stacked.

The first gate spacer 140 may be disposed on a side wall of the first gate electrode 120. The first gate spacer 140 may not be disposed between the first lower pattern BP1 and the first sheet pattern NS1, and between the sheet patterns NS11, NS12, and NS13 adjacent to each other in the third direction D3.

The first gate spacer 140 may include an inner side wall 140IS, a connection side wall 140CS, and an outer side wall 140OS. The inner side wall 140IS of the first gate spacers faces the side wall of the first gate electrode 120 extending in the second direction D2. The inner side wall 140IS of the first gate spacer 140 may extend in the second direction D2. The inner side wall 140IS of the first gate spacer 140 may be a surface that is opposite to the outer side wall 140OS of the first gate spacer 140 facing an interlayer insulating film 190.

The connection side wall 140CS of the first gate spacer 140 connects the inner side wall 140IS of the first gate spacer 140 and the outer side wall 140OS of the first gate spacer 140. In the first gate spacer 140 disposed in a region that overlaps the first extended region AP1_LR and the first reduced region AP1_SR, the connection side wall 140CS of the first gate spacer 140 may extend in the first direction D1. In the first gate spacer 140 disposed in the region that overlaps the first tapered region AP1_TA, the connection side wall 140CS of the first gate spacer 140 may extend at a predetermined angle with the first direction D1.

As an example, a thickness of the first gate spacer 140 in a region that overlaps the first tapered region AP1_TA may be equal to a thickness of the first gate spacer 140 in a region that overlaps the first extended region AP1_LR and the first reduced region AP1_SR. Here, the thickness of the first gate spacer 140 may be a thickness in the first direction D1. As another example, a thickness of the first gate spacer 140 in a region that overlaps the first tapered region AP1_TA may be different from the thickness of the first gate spacer 140 in the region that overlaps the first extended region AP1_LR and the first reduced region AP1_SR.

The first gate insulating film 130 may extend along the inner side wall 140IS of the first gate spacer 140. The first gate insulating film 130 may contact the inner side wall 140IS of the first gate spacer 140.

The first gate spacer 140 may include, for example, at least one of silicon nitride (SiN), silicon oxynitride (SiON), silicon oxide (SiO₂), silicon oxycarbonitride (SiOCN), silicon boronitride (SiBN), silicon oxyboronitride (SiOBN), silicon oxycarbide (SiOC), and a combination thereof. Although the first gate spacer 140 is shown as being a single film, this is only for convenience of explanation, and the disclosure is not limited thereto.

The first gate capping pattern 145 may be disposed on the first gate electrode 120 and the first gate spacer 140. An upper surface of the first gate capping pattern 145 may be disposed on a same level as an upper surface of the interlayer insulating film 190. Unlike the shown example, the first gate capping pattern 145 may be disposed between the first gate spacers 140.

The first gate capping pattern 145 may include, for example, at least one of silicon nitride (SiN), silicon oxynitride (SiON), silicon carbonitride (SiCN), silicon oxycarbonitride (SiOCN), and combinations thereof. The first gate capping pattern 145 may include a material having an etching selectivity with respect to the interlayer insulating film 190.

The first source/drain pattern 150A, the second source/drain pattern 150B and the third source/drain pattern 150C may be disposed on the first active pattern AP1. The first source/drain pattern 150A, the second source/drain pattern 150B and the third source/drain pattern 150C may be disposed on the first lower pattern BP1. The first source/drain pattern 150A, the second source/drain pattern 150B and the third source/drain pattern 150C may contact the first lower pattern BP1.

The first source/drain pattern 150A may be disposed on the first lower pattern BP1 of the first tapered region AP1_TA. The first source/drain pattern 150A may be connected to the second sheet patterns NS12 and the third sheet patterns NS13 adjacent to each other in the first direction D1. The first source/drain pattern 150A may contact the second sheet patterns NS12 and the third sheet patterns NS13. Unlike the shown example, as an example, the first source/drain pattern 150A may be connected to the first sheet patterns NS11 and the third sheet patterns NS13. As another example, the first source/drain pattern 150A may be disposed between the third sheet patterns NS13 adjacent to each other in the first direction D1, and may be connected to the third sheet patterns NS13 adjacent to each other in the first direction D1.

A second source/drain pattern 150B may be disposed on the first lower pattern BP1 of the first extended region AP1_LR. The second source/drain pattern 150B may be connected to the first sheet pattern NS11 and the third sheet pattern NS13 adjacent to each other in the first direction D1. The second source/drain pattern 150B may contact the first sheet patterns NS11 and the third sheet patterns NS13. Although not shown, the second source/drain pattern 150B may be disposed between the first sheet patterns NS11 adjacent to each other in the first direction D1, and may be connected to the first sheet patterns NS11 adjacent to each other in the first direction D1.

A third source/drain pattern 150C may be disposed between the first lower patterns BP1 of the first reduced region AP1_SR. The third source/drain pattern 150C may be disposed between the second sheet patterns NS12 adjacent to each other in the first direction D1 and connected to the second sheet patterns NS12 adjacent to each other in the first direction D1. The third source/drain pattern 150C may contact the second sheet patterns NS12. Although not shown, the third source/drain pattern 150C may be connected to the second sheet patterns NS12 and the third sheet pattern NS13s adjacent to each other in the first direction D1.

The first source/drain pattern 150A, the second source/drain pattern 150B, and the third source/drain pattern 150C may contact the first gate insulating film 130 included in the first inner gate structure INT_GS1. Each of the first source/drain pattern 150A, the second source/drain pattern 150B, and the third source/drain pattern 150C may include a plurality of width extended regions. In FIG. 2, an outer side wall of the first source/drain pattern 150A, an outer side wall of the second source/drain pattern 150B, and an outer side wall of the third source/drain pattern 150C may each have a wavy shape or an uneven shape.

The second source/drain pattern 150B will be described as an example. A width of the second source/drain pattern 150B in the first direction D1 in a width extended region may increase and then decrease, as it goes away from the first lower pattern BP1. The width extended region of the second source/drain pattern 150B may be defined between the first sheet patterns NS11 adjacent to each other in the third direction D3. The width extended region of the second source/drain pattern 150B may also be defined between the first lower pattern BP1 and a bottom first sheet pattern NS11 which is closest to the first lower pattern BP1 among the first sheet patterns NS11. In each of the width expansion regions of the second source/drain pattern 150B, the width of the second source/drain pattern 150B in the first direction D1 is the greatest when measured at a mid-point between the bottom first sheet pattern NS11 and the first lower pattern BP1 and/or between the first sheet patterns NS11 adjacent to each other in the third direction D3.

The first source/drain pattern 150A, the second source/drain pattern 150B, and the third source/drain pattern 150C may contact the first gate spacer 140. For example, each of the first source/drain pattern 150A, the second source/drain pattern 150B, and the third source/drain pattern 150C may contact the connection side wall 140CS of the first gate spacer 140. Also, each of the first source/drain pattern 150A, the second source/drain pattern 150B, and the third source/drain pattern 150C may contact the outer side wall 140OS of the first gate spacer 140. In the plan view, each of the first source/drain pattern 150A, the second source/drain pattern 150B, and the third source/drain pattern 150C may be disposed on a part of the outer side wall 140OS of the first gate spacer 140.

Each of the first source/drain pattern 150A, the second source/drain pattern 150B, and the third source/drain pattern 150C may include an epitaxial pattern. Each of the first source/drain pattern 150A, the second source/drain pattern 150B, and the third source/drain pattern 150C may include a semiconductor material.

The first source/drain pattern 150A may include a first semiconductor liner film 151A and a first semiconductor filling film 152A. The second source/drain pattern 150B may include a second semiconductor liner film 151B and a second semiconductor filling film 152B. The third source/drain pattern 150C may include a third semiconductor liner film 151C and a third semiconductor filling film 152C.

The semiconductor liner films 151A, 151B and 151C may be disposed on the first lower pattern BP1. The semiconductor filling films 152A, 152B, and 152C may be disposed on the semiconductor liner films 151A, 151B, and 151C, respectively. Although the semiconductor filling films 152A, 152B, and 152C are shown to be single films, this is only for convenience of explanation, and the disclosure is not limited thereto.

The first semiconductor liner film 151A may contact the second sheet patterns NS12, the third sheet patterns NS13, the first lower pattern BP1 and the first inner gate structure INT_GS 1. The first semiconductor liner film 151A may contact the first gate insulating film 130 of the first inner gate structure INT_GS 1.

The semiconductor liner films 151A, 151B and 151C may contact the sheet patterns NS11, NS12 and NS13, the first lower pattern BP1, and the first inner gate structure INT_GS1. The semiconductor liner films 151A, 151B and 151C may contact the first gate insulating film 130 of the first inner gate structure INT_GS1.

The semiconductor filling films 152A, 152B, and 152C may contact the semiconductor liner films 151A, 151B, and 151C. The semiconductor filling films 152A, 152B and 152C may not contact the sheet patterns NS11, NS12 and NS13, the first lower pattern BP1, and the first inner gate structure INT _GS1.

Each of the semiconductor liner films 151A, 151B, and 151C may include silicon-germanium. Each of the semiconductor liner films 151A, 151B, and 151C may include a silicon-germanium film. Each of the semiconductor liner films 151A, 151B, and 151C may be an epitaxial semiconductor film. A germanium fraction of the first semiconductor liner film 151A may be equal to a germanium fraction of each of the second semiconductor liner film 151B and a germanium fraction of the third semiconductor liner film 151C. Each of the first semiconductor liner film 151A, the second semiconductor liner film 151B, and the third semiconductor liner film 151C may be formed through a same epitaxial process. The first semiconductor liner film 151A, the second semiconductor liner film 151B, and the third semiconductor liner film 151C may be formed through a single epitaxial process.

Each of the semiconductor filling films 152A, 152B, and 152C may include a silicon-germanium film. Each of the semiconductor filling films 152A, 152B, and 152C may be an epitaxial semiconductor film. The germanium fraction of the first semiconductor filling film 152A may be equal to the germanium fraction of each of the second semiconductor filling film 152B and the germanium fraction of the third semiconductor filling film 152C. The germanium fraction of each of the semiconductor filling films 152A, 152B, and 152C may be greater than the germanium fraction of each of the semiconductor liner films 151A, 151B, and 151C.

The semiconductor liner films 151A, 151B, and 151C and the semiconductor filling films 152A, 152B, and 152C may include doped p-type impurities. For example, the p-type impurities may include at least one boron (B), indium (In) and gallium (Ga), but not limited thereto.

Although not shown, the source/drain patterns 150A, 150B, and 150C may further include a semiconductor capping film disposed on the semiconductor filling films 152A, 152B, and 152C. As an example, the semiconductor capping film may include a silicon film. As another example, the semiconductor capping film may include a silicon-germanium film. When the semiconductor capping film includes a silicon-germanium film, the germanium fraction of the semiconductor capping film may be smaller than the germanium fraction of each of the semiconductor filling films 152A, 152B, and 152C.

Shapes of the source/drain patterns 150A, 150B, and 150C will be described below in reference to FIGS. 2, and 8 to 11.

The third sheet pattern NS13 may include a first side wall and a second side wall opposite to each other in the first direction D1. For example, the first side wall of the third sheet pattern NS13 may contact the first source/drain pattern 150A, and the second side wall of the third sheet pattern NS13 may contact the second source/drain pattern 150B.

The second sheet pattern NS12 may include a first side wall and a second side wall opposite to each other in the first direction D1. For example, the first side wall of the second sheet pattern NS12 may contact the first source/drain pattern 150A, and the second side wall of the second sheet pattern NS12 may contact the third source/drain pattern 150C.

In FIGS. 8 and 9, the first source/drain pattern 150A may include a first interface 150A_F1 that contacts the second sheet pattern NS12, and a second interface 150A_F2 that contacts the third sheet pattern NS13. The first interface 150A_F1 of the first source/drain pattern 150A may be opposite to the second interface 150A_F2 of the first source/drain pattern 150A in the first direction D1.

The first interface 150A_F1 of the first source/drain pattern 150A and the second interface 150A_F2 of the first source/drain pattern 150A may be included in the first semiconductor liner film 151A. The first interface 150A_F1 of the first source/drain pattern150A and the second interface 150A_F2 of the first source/drain pattern 150A may be parts of an outer side surface of the first semiconductor liner film 151A. The first interface 150A_F1 of the first source/drain pattern 150A and the second interface 150A_F2 of the first source/drain pattern 150A may be defined by the first semiconductor liner film 151A.

A width W21 of the first interface 150A_F1 of the first source/drain pattern 150A in the second direction D2 may be different from a width W22 of the second interface 150A_F2 of the first source/drain pattern 150A in the second direction D2. For example, the width W21 of the first interface 150A_F1 of the first source/drain pattern 150A in the second direction D2 may be smaller than the width W22 of the second interface 150A_F2 of the first source/drain pattern 150A in the second direction D2.

The first source/drain pattern 150A may include a first horizontal side wall 150A_LSW1 and a second horizontal side wall 150A_LSW2 that are opposite to each other in the second direction D2.

The first horizontal side wall 150A_LSW1 of the first source/drain pattern 150A may include a first horizontal sloped side wall 150A_LSW11 and a second horizontal sloped side wall 150A_LSW12. The first horizontal sloped side wall 150A_LSW11 and the second horizontal sloped side wall 150A_LSW12 may extend from the outer side wall 140OS of the first gate spacer 140, respectively.

The first horizontal side wall 150A_LSW1 of the first source/drain pattern 150A may include a first horizontal intersection 150A_LFC1 at which the first horizontal sloped side wall 150A_LSW11 and the second horizontal sloped side wall 150A_LSW12 meet. Although the first horizontal side wall 150A_LSW1 of the first source/drain pattern 150A near the first horizontal intersection 150A_LFC1 is shown to have a rounded shape, the disclosure is not limited thereto. Unlike the shown example, the first horizontal side wall 150A_LSW1 of the first source/drain pattern 150A near the first horizontal intersection 150A_LFC1 may have an angled apex shape, according to an embodiment.

The second horizontal side walls 150A_LSW2 of the first source/drain pattern 150A may include a third horizontal sloped side wall 150A_LSW21 and a fourth horizontal sloped side wall 150A_LSW22. The third horizontal sloped side wall 150A_LSW21 and the fourth horizontal sloped side wall 150A_LSW22 may extend from the outer side wall 140OS of the first gate spacer 140, respectively.

The second horizontal side wall 150A_LSW2 of the first source/drain pattern 150A may include a second horizontal intersection 150A_LFC2 at which the third horizontal sloped side wall 150A_LSW21 and the fourth horizontal sloped side wall 150A_LSW22 meet.

The first horizontal side wall 150A_LSW1 of the first source/drain pattern 150A and the second horizontal side wall 150A_LSW2 of the first source/drain pattern 150A may be defined by the first semiconductor filling film 152A.

The first horizontal side wall 150A_LSW1 of the first source/drain pattern 150A may be asymmetric with the second horizontal side wall 150A_LSW2 of the first source/drain pattern.

A distance L11 from the first interface 150A_F1 of the first source/drain pattern 150A to the first horizontal intersection 150A_LFC1 may be greater than a distance L12 from the second interface 150A_F2 of the first source/drain pattern 150A to the first horizontal intersection 150A_LFC1.

When the first horizontal side wall 150A_LSW1 of the first source/drain pattern 150A has a rounded shape near the first horizontal intersection 150A_LFC1, the distance L11 may be a distance from the first interface 150A_F1 to an imaginary point at which the first horizontal inclined side wall 150A_LSW11 and the second horizontal sloped side wall 150A_LSW12 extend and meet.

A distance L21 from the first interface 150A_F1 of the first source/drain pattern 150A to the second horizontal intersection 150A_LFC2 may be equal to a distance L22 from the second interface 150A_F2 of the first source/drain pattern 150A to the second horizontal intersection 150A_LFC2.

In other words, the distance L11 from the first interface 150A_F1 of the first source/drain pattern 150A to the first horizontal intersection 150A_LFC1 may be different from the distance L21 from the first interface 150A_F1 of the first source/drain pattern 150A to the second horizontal intersection 150A_LFC2. For example, the distance L11 from the first interface 150A_F1 of the first source/drain pattern 150A to the first horizontal intersection 150A_LFC1 may be greater than the distance L21 from the first interface 150A_F1 of the first source/drain pattern 150A to the second horizontal intersection 150A_LFC2.

The distance L12 from the second interface 150A_F2 of the first source/drain pattern 150A to the first horizontal intersection 150A_LFC1 may be smaller than the distance L22 from the second interface 150A_F2 of the first source/drain pattern 150A to the second horizontal intersection 150A_LFC2.

A difference in positions of the first horizontal intersection 150A_LFC1 and the second horizontal intersection 150A_LFC2 may be explained using a distance from the outer side wall 140OS of the first gate spacer 140.

A distance L11_S from the outer side wall 140OS of the first gate spacer 140 that contacts the second sheet pattern NS12 to the first horizontal intersection 150A_LFC1 may be greater than a distance L12_S from the outer side wall 140OS of the first gate spacer 140 that contacts the third sheet pattern NS13 to the first horizontal intersection 150A_LFC1.

A distance L21_S from the outer side wall 140OS of the first gate spacer 140 that contacts the second sheet pattern NS12 to the second horizontal intersection 150A_LFC2 may be equal to a distance L22_S from the outer side wall 140OS of the first gate spacer 140 that contacts the third sheet pattern NS13 to the second horizontal intersection 150A_LFC2.

The first interface 150A_F1 of the first source/drain pattern 150A may include a first end point 150A_P11 and a second end point 150A_P12 that are spaced apart from each other in the second direction D2. The second interface 150A_F2 of the first source/drain pattern 150A may include a first end point 150A_P21 and a second end point 150A_P22 that are spaced apart from each other in the second direction D2.

The first end point 150A_P11 of the first interface 150A_F1 and the second end point 150A_P12 of the first interface 150A_F1 may be points at which the first interface 150A_F1 of the first source/drain pattern 150A and the connection side wall 140CS of the first gate spacer 140 meet. The first end point 150A_P21 of the second interface 150A_F2 and the second end point 150A_P22 of the second interface 150A_F2 may be points at which the second interface 150A_F2 of the first source/drain pattern 150A and the connection side wall 140CS of the first gate spacer 140 meet.

The first end point 150A_P11 of the first interface 150A_F1 may be closer to the first horizontal side wall 150A_LSW1 of the first source/drain pattern 150A than the second end point 150A_P12 of the first interface 150A_F1. The first end point 150A_P21 of the second interface 150A_F2 may be closer to the first horizontal side wall 150A_LSW1 of the first source/drain pattern 150A than the second end point 150A_P22 of the second interface 150A_F2.

A first end point extension line 150A_EX1 may extend in the first direction D1 beyond the first end point 150A_P11 of the first interface 150A_F1. A second end point extension line 150A_EX2 may extend in the first direction D1 beyond the second end point 150A_P12 of the first interface 150A_F1. The first end point extension line 150A_EX1 and the second end point extension line 150A_EX2 may be parallel to each other. For example, the first end point extension line 150A_EX1 may be parallel to the first side wall BP1_SW1 in the first reduced region AP1_SR of FIG. 1. The second end point extension line 150A_EX2 may be parallel to the second side wall BP1_SW2 in the first reduced region AP1 _SR of FIG. 1.

In the semiconductor device according to some embodiments, the first end point extension line 150A_EX1 may not pass through first end point 150A_P21 of the second interface 150A_F2, while the second end point extension line 150A_EX2 may pass through the second end point 150A_P22 of the second interface 150A_F2.

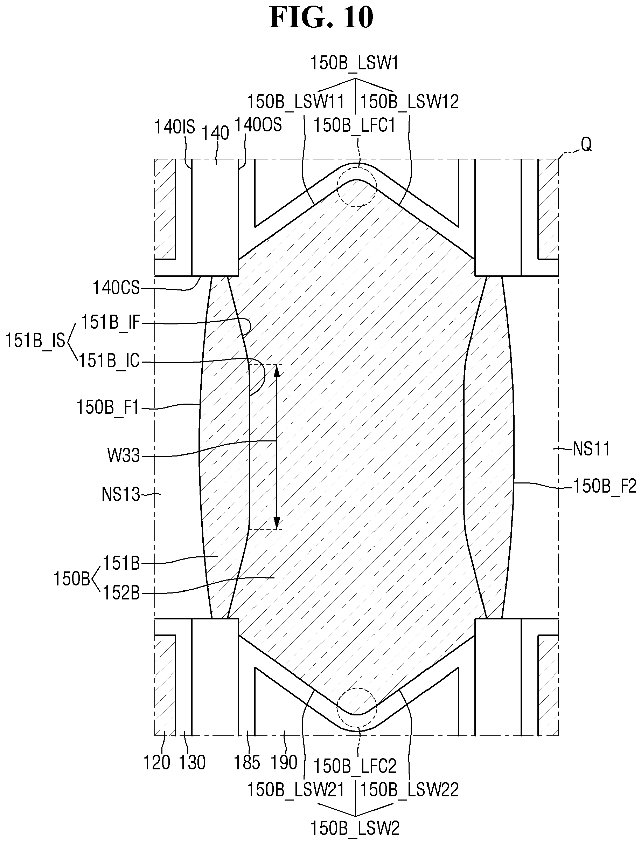

In FIGS. 8 and 10, the second source/drain pattern 150B may include a first interface 150B_F1 that contacts the third sheet pattern NS13, and a second interface 150B_F2 that contacts the first sheet pattern NS11. The first interface 150B_F1 of the second source/drain pattern 150B may be opposite to the second interface 150B_F2 of the second source/drain pattern 150B in the first direction D1.

The first interface 150B_F1 of the second source/drain pattern 150B and the second interface 150B_F2 of the second source/drain pattern 150B may be included in the second semiconductor liner film 151B. The first interface 150B_F1 of the second source/drain pattern 150B and the second interface 150B_F2 of the second source/drain pattern 150B may be parts of an outer side surface of the second semiconductor liner film 151B. The first interface 150B_F1 of the second source/drain pattern 150B and the second interface 150B_F2 of the second source/drain pattern 150B may be defined by the second semiconductor liner film 151B.

A width W23 of the first interface 150B_F1 of the second source/drain pattern 150B in the second direction D2 may be greater than a width W22 of the second interface 150A_F2 of the first source/drain pattern. A width of the second interface 150B_F2 of the second source/drain pattern 150B in the second direction D2 may be equal to a width W23 of the first interface 150B_F1 of the second source/drain pattern 150B.

The second source/drain pattern 150B may include a first horizontal side wall 150B_LSW1 and a second horizontal side wall 150B_LSW2 that are opposite to each other in the second direction D2.

The first horizontal side wall 150B_LSW1 of the second source/drain pattern 150B may include a first horizontal sloped side wall 150B_LSW11 and a second horizontal sloped side wall 150B_LSW12. The first horizontal sloped side wall 150B_LSW11 and the second horizontal sloped side wall 150B_LSW12 may extend from the outer side wall 140OS of the first gate spacer 140, respectively.

The first horizontal side wall 150B_LSW1 of the second source/drain pattern 150B may include a third horizontal intersection 150B_LFC1 at which the first horizontal sloped side wall 150B _LSW11 and the second horizontal sloped side wall 150B_LSW12 meet.

The second horizontal side wall 150B_LSW2 of the second source/drain pattern 150B may include a third horizontal sloped side wall 150B_LSW21 and a fourth horizontal sloped side wall 150B _LSW22. The third horizontal sloped side wall 150B_LSW21 and the fourth horizontal sloped side wall 150B _LSW22 may extend from the outer side wall 140OS of the first gate spacer 140, respectively.

The second horizontal side wall 150B_LSW2 of the second source/drain pattern 150B may include a fourth horizontal intersection 150B_LFC2 at which the third horizontal sloped side wall 150B_LSW21 and the fourth horizontal sloped side wall 150B_LSW22 meet.

The first horizontal side wall 150B_LSW1 of the second source/drain pattern 150B and the second horizontal side wall 150B_LSW2 of the second source/drain pattern 150B may be defined by the second semiconductor filling film 152B.

The first horizontal side wall 150B_LSW1 of the second source/drain pattern 150B may be symmetrical with the second horizontal side wall 150B_LSW2 of the second source/drain pattern 150B.

A distance L31 from the first interface 150B_F1 of the second source/drain pattern 150B to the third horizontal intersection 150B_LFC1 may be equal to a distance L32 from the second interface 150B_F2 of the second source/drain pattern 150B to the third horizontal intersection 150B_LFC1.

A distance L41 from the first interface 150B_F1 of the second source/drain pattern 150B to the fourth horizontal intersection 150B_LFC2 may be equal to a distance L42 from the second interface 150B_F2 of the second source/drain pattern 150B to the fourth horizontal intersection 150B_LFC2.

The distance L31 from the first interface 150B_F1 of the second source/drain pattern 150B to the third horizontal intersection 150B_LFC1 may be equal to the distance L41 from the first interface 150B_F1 of the second source/drain pattern 150B to the fourth horizontal intersection 150B_LFC2.

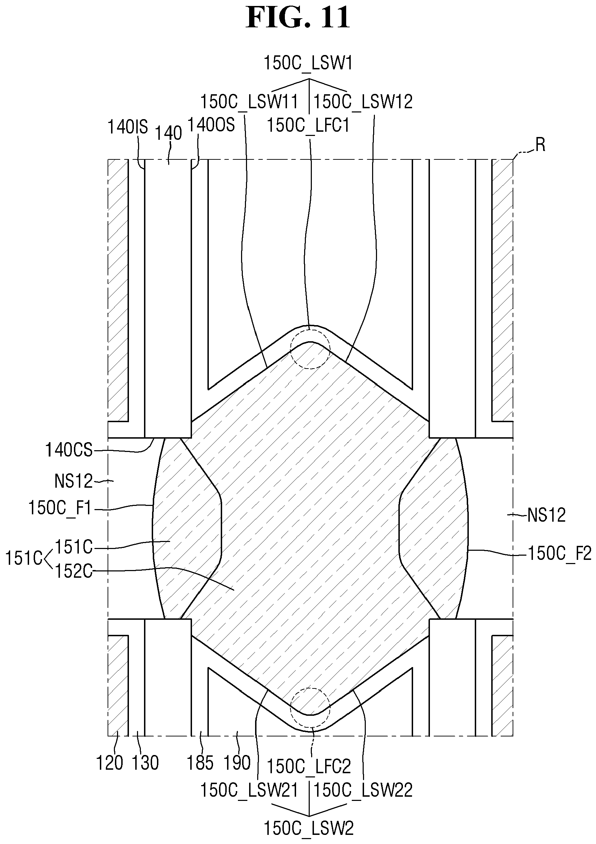

In FIGS. 8 and 11, the third source/drain pattern 150C may include a first interface 150C_F1 that contacts the second sheet pattern NS12, and a second interface 150C_F2 that contacts the second sheet pattern NS12 which is different from the second sheet pattern that may contact the first interface 150C_F1. The first interface 150C_F1 of the third source/drain pattern 150C may be opposite to the second interface 150C_F2 of the third source/drain pattern 150C in the first direction D1.

The first interface 150C_F1 of the third source/drain pattern 150C and the second interface 150C_F2 of the third source/drain pattern 150C may be included in the third semiconductor liner film 151C. The first interface 150C_F1 of the third source/drain pattern 150C and the second interface 150C_F2 of the third source/drain pattern 150C may be parts of an outer side surface of the third semiconductor liner film 151C.

A width of the second interface 150C_F2 of the third source/drain pattern 150C in the second direction D2 may be equal to a width of the first interface 150C_F1 of the third source/drain pattern 150C in the second direction D2. The width of the second interface 150C_F2 of the third source/drain pattern 150C in the second direction D2 may be equal to the width W21 of the first interface 150A_F1 of the first source/drain pattern.

The third source/drain pattern 150C may include a first horizontal side wall 150C_LSW1 and a second horizontal side wall 150C_LSW2 that are opposite to each other in the second direction D2.

The first horizontal side wall 150C_LSW1 of the third source/drain pattern 150C may include a first horizontal sloped side wall 150C_LSW11 and a second horizontal sloped side wall 150C_LSW12. The first horizontal sloped side wall 150C_LSW11 and the second horizontal sloped side wall 150C_LSW12 may extend from the outer side wall 140OS of the first gate spacer 140, respectively.

The first horizontal side wall 150C_LSW1 of the third source/drain pattern 150C may include a fifth horizontal intersection 150C_LFC1 at which the first horizontal sloped side wall 150C_LSW11 and the second horizontal sloped side wall 150C_LSW12 meet.

The second horizontal side wall 150C_LSW2 of the third source/drain pattern 150C may include a third horizontal sloped side wall 150C_LSW21 and a fourth horizontal sloped side wall 150C _LSW22. The third horizontal sloped side wall 150C_LSW21 and the fourth horizontal sloped side wall 150C _LSW22 may extend from the outer side wall 140OS of the first gate spacer 140, respectively.

The second horizontal side wall 150C_LSW2 of the third source/drain pattern 150C may include a sixth horizontal intersection 150C_LFC2 at which the third horizontal sloped side wall 150C_LSW21 and the fourth horizontal sloped side wall 150C_LSW22 meet.

The first horizontal side wall 150C_LSW1 of the third source/drain pattern 150C and the second horizontal side wall 150C_LSW2 of the third source/drain pattern 150C may be defined by the third semiconductor filling film 152C.

The first horizontal side wall 150C_LSW1 of the third source/drain pattern 150C may be symmetrical with the second horizontal side wall 150C_LSW2 of the third source/drain pattern 150C.

A distance L51 from the first interface 150C_F1 of the third source/drain pattern 150C to the fifth horizontal intersection 150C_LFC1 may be equal to a distance L52 from the second interface 150C_F2 of the third source/drain pattern 150C to the fifth horizontal intersection 150C_LFC1.

A distance L61 from the first interface 150C_F1 of the third source/drain pattern 150C to the sixth horizontal intersection 150C_LFC2 may be equal to a distance L62 from the second interface 150C_F2 of the third source/drain pattern 150C to the sixth horizontal intersection 150C_LFC2.

The distance L51 from the first interface 150C_F1 of the third source/drain pattern 150C to the fifth horizontal intersection 150C_LFC1 may be equal to a distance L61 from the first interface 150C_F1 of the third source/drain pattern 150C to the sixth horizontal intersection 150C_LFC2.

Here, the distances L11, L11-S, L12, L12_S, L21, L21_S, L22, L22_S, L31, L32, L41, L42, L51, L52, L61 and L62 may all be horizontal distances measured in the first direction D2.

In FIG. 9, in a plan view, the first semiconductor liner film 151A may include a first sub-liner film 151A1 that contacts the second sheet pattern NS12, and a second sub-liner film 151A2 that contacts the third sheet pattern NS13. The first semiconductor filling film 152A may be disposed between the first sub-liner film 151A1 and the second sub-liner film 151A2.

In FIGS. 8 to 10, the first interface 150A_F1 of the first source/drain pattern 150A may be defined by the first sub-liner film 151A1. The second interface 150A_F2 of the first source/drain pattern 150A may be defined by the second sub-liner film 151A2. A width W21 of the first sub-liner film 151A1 in the second direction D2 may be smaller than a width W22 of the second sub-liner film 151A2 in the second direction D2.

A width W23 of the second semiconductor liner film 151B in the second direction D2 may be greater than the width W21 of the first sub-liner film 151A1 and the width W22 of the second sub-liner film 151A2.

A thickness T11 of the first sub-liner film 151A1 in the first direction D1 may be different from a thickness T12 of the second sub-liner film 151A2 in the first direction D1. For example, the thickness T11 of the first sub-liner film 151A1 may be greater than the thickness T12 of the second sub-liner film 151A2.

A thickness T13 of the second semiconductor liner film 151B in the first direction D1 may be different from the thickness T12 of the second sub-liner film 151A2. For example, the thickness T13 of the second semiconductor liner film 151B may be smaller than the thickness T12 of the second sub-liner film 151A2.

The first sub-liner film 151A1 may include an inner side surface 151A1_IS facing the first semiconductor filling film 152A. The second sub-liner film 151A2 may include an inner side surface 151A2_IS facing the first semiconductor filling film 152A. The second semiconductor liner film 151B may include an inner side surface 151B_IS facing the second semiconductor filling film 152B.

The inner side surface 151A1_IS of the first sub-liner film 151A1 may include a first connecting portion 151A1_IC, extending in the second direction D2, and a first facet portion 151A1_IF. The inner side surface 151A2_IS of the second sub-liner film 151A2 may include a second connecting portion 151A2_IC, extending in the second direction D2, and a second facet portion 151A2_IF. The inner side surface 151B_IS of the second semiconductor liner film 151B may include a third connecting portion 151B_IC, extending in the second direction D2, and a third facet portion 151B_IF.

The first facet portion 151A1_IF, the second facet portion 151A2_IF, and the third facet portion 151B_IF may each extend from the connection side wall 140CS of the first gate spacer 140.

A width W31 of the first connecting portion 151A1_IC in the second direction D2 may be different from a width W32 of the second connecting portion 151A2_IC in the second direction D2. For example, the width W31 of the first connecting portion 151A1_IC may be smaller than the width W32 of the second connecting portion 151A2_IC.

A width W33 of the third connecting portion 151B_IC in the second direction D2 may be different from a width W32 of the second connecting portion 151A2_IC. For example, the width W33 of the third connecting portion 151B_IC may be greater than the width W32 of the second connecting portion 151A2_IC.

Unlike the shown example, as a length of the first interface 150A_F1 of the first source/drain pattern 150A in the second direction D2 decreases, the inner side surface 151A1_IS of the first sub-liner film 151A1 may not include the first connecting portion 151A1_IC.

Shapes of the source/drain patterns 150A, 150B, and 150C in a cross-sectional view will be described below, using FIGS. 1, 2 and 5 to 7.

The first source/drain pattern 150A may include a bottom surface 150A_BS and vertical side walls 150A_VSW opposite to each other in the second direction D2. The bottom surface 150A_BS of the first source/drain pattern 150A may contact the first lower pattern BP1 of the first tapered region AP1_TA.

A vertical side walls 150A_VSW of the first source/drain pattern 150A may extend in the third direction D3 from the bottom surface 150A_BS of the first source/drain pattern. Each of the vertical side walls 150A_VSW of the first source/drain pattern 150A may include a lower sloped side wall 150A_VSW1, an upper sloped side wall 150A_VSW2, and a first vertical facet intersection 150A_VFC. The first vertical facet intersection 150A_VFC is a point at which the lower sloped side wall 150A_VSW1 of the first source/drain pattern 150A and the upper sloped side wall 150A_VSW2 of the first source/drain pattern 150A meet. In the cross-sectional view, a width of the first source/drain pattern 150A in the second direction D2 may be maximum at the first vertical facet intersection 150A_VFC.

The second source/drain pattern 150B may include a bottom surface 150B_BS and vertical side walls 150B_VSW opposite to each other in the second direction D2. The bottom surface 150B_BS of the second source/drain pattern 150B may contact the first lower pattern BP1 of the first extended region AP1_LR.

The vertical side walls 150B_VSW of the second source/drain pattern 150B may extend in the third direction D3 from the bottom surface 150B_BS of the second source/drain pattern 150B. Each of the vertical side walls 150B_VSW of the second source/drain pattern 150B may include a lower sloped side wall 150B_VSW1, an upper sloped side wall 150B_VSW2, and a second vertical facet intersection 150B_VFC. The second vertical facet intersection 150B_VFC is a point at which the lower sloped side wall 150B_VSW1 of the second source/drain pattern 150B and the upper sloped side wall 150B_VSW2 of the second source/drain pattern 150B meet. In the cross-sectional view, a width of the second source/drain pattern 150B in the second direction D2 may be maximum at the second vertical facet intersection 150B_VFC.

The third source/drain pattern 150C may include a bottom surface 150C_BS and vertical side walls 150C_VSW opposite to each other in the second direction D2. The bottom surface 150C_BS of the third source/drain pattern 150C may contact the first lower pattern BP1 of the first reduced region AP1_SR.

The vertical side walls 150C_VSW of the third source/drain pattern 150C may extend in the third direction D3 from the bottom surface 150C_BS of the third source/drain pattern 150C. Each of the vertical side walls 150C_VSW of the third source/drain pattern 150C may include a lower sloped side wall 150C_VSW1, an upper sloped side wall 150C_VSW2, and a third vertical facet intersection 150C_VFC. The third vertical facet intersection 150C_VFC is a point at which the lower sloped side walls 150C_VSW1 of the third source/drain pattern 150C and the upper sloped side walls 150C_VSW2 of the third source/drain pattern 150C meet. In the cross-sectional view, a width of the third source/drain pattern 150C in the second direction D2 may be maximum at the third vertical facet intersection 150C_VFC.

The second source/drain pattern 150B may include an upper surface 150B_US that connects the vertical side walls 150B_VSW of the second source/drain pattern 150B opposite to each other in the second direction D2. Although not shown, when there is no first source/drain contact plug 180, the first source/drain pattern 150A may include an upper surface that connects the vertical side walls 150A_VSW of the first source/drain pattern. The third source/drain pattern 150C may or may not include an upper surface that connects the vertical side walls 150C_VSW of the third source/drain pattern 150C.

The first source/drain pattern 150A will be described as an example. A width W43 of the bottom surface 150A_BS of the first source/drain pattern 150A in the second direction D2 is equal to the width of the interface between the first source/drain pattern 150A and the first lower pattern BP1.

A width W43 of the bottom surface 150A_BS of the first source/drain pattern 150A may be smaller than a width W41 of the bottom surface 150B_BS of the second source/drain pattern 150B in the second direction D2. The width W43 of the bottom surface 150A_BS of the first source/drain pattern 150A may be greater than a width W42 of the bottom surface 150C_BS of the third source/drain pattern 150C in the second direction D2.

A thickness T23 of the first semiconductor liner film 151A in the third direction D3 may be different from a thickness T21 of the second semiconductor liner film 151B in the third direction D3. For example, the thickness T23 of the first semiconductor liner film 151A may be greater than the thickness T21 of the second semiconductor liner film 151B.

The thickness T23 of the first semiconductor liner film 151A may be different from a thickness T22 of the third semiconductor liner film 151C in the third direction D3. For example, the thickness T23 of the first semiconductor liner film 151A may be smaller than the thickness T22 of the third semiconductor liner film 151C.

A height H13 from the first lower pattern BP1 to the first vertical facet intersection 150A_VFC may be different from a height H11 from the first lower pattern BP1 to the second vertical facet intersection 150B_VFC. For example, the height H13 from the first lower pattern BP1 to the first vertical facet intersection 150A_VFC may be greater than the height H11 from the first lower pattern BP1 to the second vertical facet intersection 150B_VFC.

The height H13 from the first lower pattern BP1 to the first vertical facet intersection 150A_VFC may be different from the height H12 from the first lower pattern BP1 to the third vertical facet intersection 150C_VFC. For example, the height H13 from the first lower pattern BP1 to the first vertical facet intersection 150A_VFC may be smaller than the height H12 from the first lower pattern BP1 to the third vertical facet intersection 150C_VFC.

In FIG. 2, a height of the first source/drain pattern 150A may be greater than a height of the third source/drain pattern 150C. In other words, a length from a bottom end the first source/drain pattern 150A to the upper surface of the first source/drain pattern 150A in the third direction D3 may be greater than a length from a bottom end of the third source/drain pattern 150C to the upper surface of the third source/drain pattern 150C.

The height of the second source/drain pattern 150B may be greater than the height of the third source/drain pattern 150C.

A height relation of the vertical facet intersections 150A_VFC, 150B_VFC, and 150C_VFC as described above may also be applied to source/drain patterns on the lower patterns spaced apart from each other. In addition, a thickness relation of the semiconductor liner films 151A, 151B, and 151C as described above may also be applied to the source/drain patterns on the lower patterns that are spaced apart from each other.

Third, fourth and fifth lower patterns spatially spaced apart from each other and extending long in the first direction D1 are assumed to be disposed on a substrate. For example, a width of the fourth lower pattern in the second direction D2 may be greater than a width of the third lower pattern in the second direction D2 and smaller than a width of the fifth lower pattern in the second direction D2.

In this case, the first source/drain pattern 150A may be disposed on the fourth lower pattern. The second source/drain pattern 150B may be disposed on the fifth lower pattern. The third source/drain pattern 150C may be disposed on the third lower pattern.

A length from the fourth lower pattern to the first vertical facet intersection 150A_VFC in the third direction D3 may be smaller than a length from the third lower pattern to the third vertical facet intersection 150C_VFC in the third direction D3. The length from the fourth lower pattern to the first vertical facet intersection 150A_VFC in the third direction D3 may be greater than a length from the fifth lower pattern to the second vertical facet intersection 150B_VFC in the third direction D3.

A source/drain etching stop film 185 may extend along the outer side wall 140OS of the first gate spacers 140 and profiles of the source/drain patterns 150A, 150B and 150C. The source/drain etching stop film 185 may be disposed on the upper surface of the field insulating film 105.

The source/drain etching stop film 185 may include a material having an etching selectivity with respect to the interlayer dielectric film 190, which will be described later. The source/drain etching stop film 185 may include, for example, at least one of silicon nitride (SiN), silicon oxynitride (SiON), silicon oxycarbonitride (SiOCN), silicon boronitride (SiBN), silicon oxyboronitride (SiOBN), silicon oxycarbide (SiOC), and combinations thereof.

The interlayer insulating film 190 may be disposed on the etching stop film 185. The interlayer insulating film 190 may be disposed on the source/drain patterns 150A, 150B, and 150C. The interlayer insulating film 190 may not be disposed on the upper surface of the first gate capping pattern 145. For example, the upper surface of the interlayer insulating film 190 may be disposed on the same level as the upper surface of the first gate capping pattern 145.

The interlayer insulating film 190 may include, for example, at least one of silicon oxide, silicon nitride, silicon oxynitride, and a low dielectric constant material. The low dielectric constant material may include, for example, but not limited to, at least one of Fluorinated TetraEthylOrthoSilicate (FTEOS), Hydrogen SilsesQuioxane (HSQ), BisbenzoCycloButene (BCB), TetraMethylOrthoSilicate (TMOS), OctaMethylCycloTetraSiloxane (OMCTS), HexaMethylDiSiloxane (HMDS), TriMethylSilyl Borate (TMSB), DiAcetoxyDitertiaryButoSiloxane (DADBS), TriMethylSilil Phosphate (TMSP), PolyTetraFluoroEthylene (PTFE), Tonen SilaZen (TOSZ), Fluoride Silicate Glass (FSG), polyimide nanofoams such as polypropylene oxide, Carbon Doped silicon Oxide (CDO), Organo Silicate Glass (OSG), SiLK, Amorphous Fluorinated Carbon, silica aerogels, silica xerogels, mesoporous silica or combinations thereof.

The first source/drain contact plug 180 may be disposed on each of the source/drain patterns 150A, 150B, and 150C. The first source/drain contact plug 180 may be connected to each of the source/drain patterns 150A, 150B, and 150C. The first source/drain contact plug 180 may pass through the interlayer insulating layer 190 and the source/drain etching stop film 185, and may be connected to each of the source/drain patterns 150A, 150B and 150C.

A first contact silicide film 155 may be further disposed between the first source/drain contacts plug 180 and each of the source/drain patterns 150A, 150B, and 150C.

Although the first source/drain contact 180 plug is shown to be a single film, this is only for convenience of explanation, and the disclosure is not limited thereto. The first source/drain contact plug 180 may include, for example, at least one of metal, metal alloy, conductive metal nitride, conductive metal carbide, conductive metal oxide, conductive metal carbonitride, and two-dimensional material (2D material).

The first contact silicide film 155 may include metal silicide.

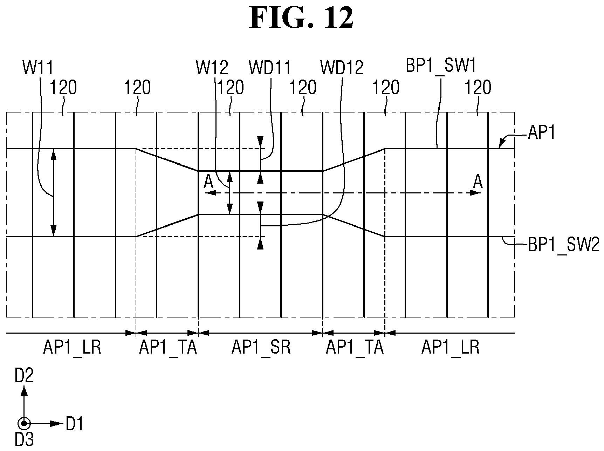

FIGS. 12 to 14 are diagrams for explaining a semiconductor device according to some embodiments. For convenience of explanation, the explanation will focus on points that are different from those explained using FIGS. 1 to 11.

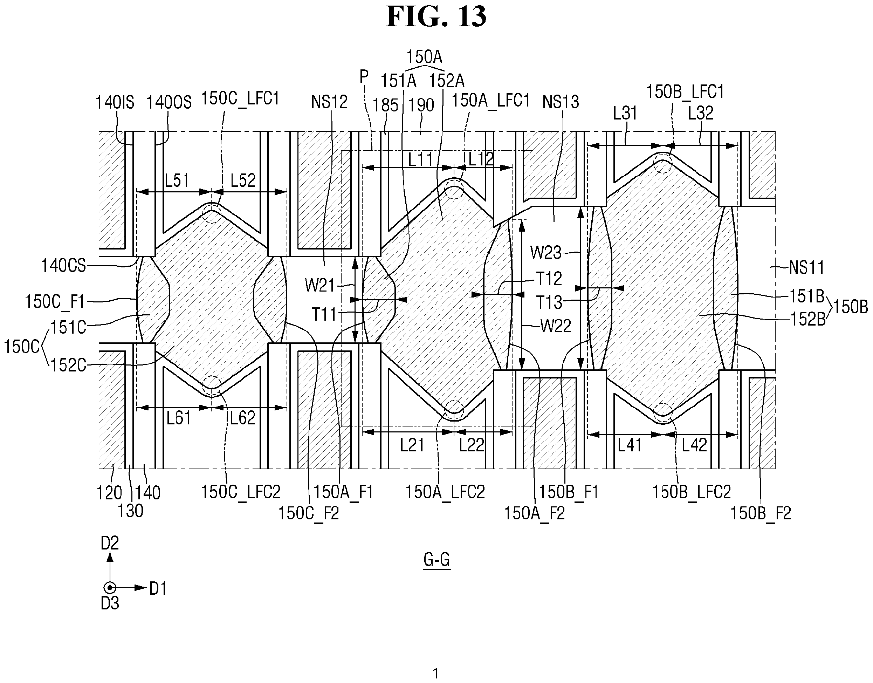

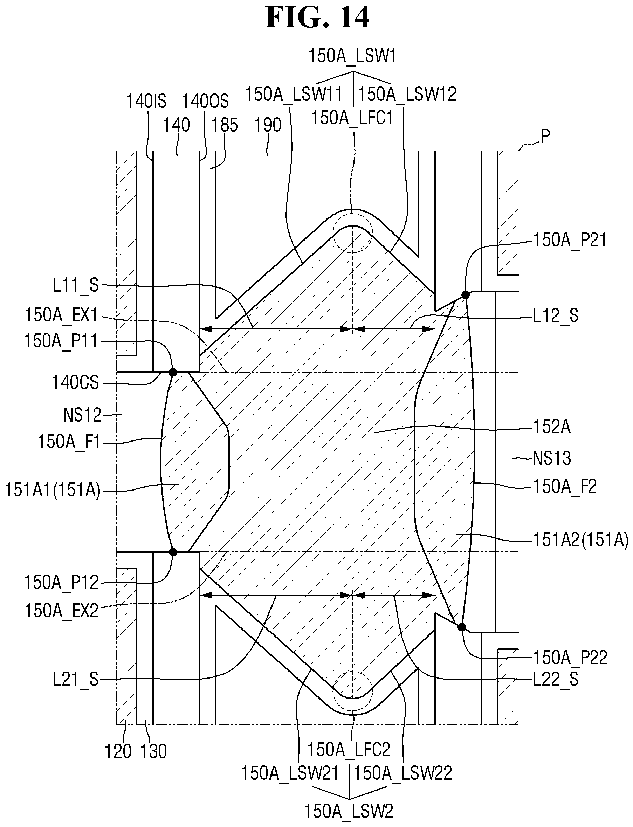

For reference, FIG. 12 is a layout diagram for explaining a semiconductor device according to some embodiments. A cross-sectional view taken along A-A of FIG. 12 may be the same as FIG. 2. FIG. 13 is a plan view taken along G-G of FIG. 2 and viewed from above. FIG. 14 is an enlarged view of a region P of FIG. 13.

Referring to FIGS. 12 to 14, in the semiconductor device according to some embodiments, in the plan view, the first side wall BP1_SW1 of the first lower pattern BP1 and the second side wall BP1_SW2 of the first lower pattern BP1 may each extend in the first direction D1, and have an uneven shape.

The first side wall BP1_SW1 and the second side wall BP1_SW2 in the first extended region AP1_LR are not linearly aligned with the first side wall BP1_SW1 and the second side wall BP1_SW2 in the first reduced region AP1_SR, respectively, along the first direction D1.

In the plan view, the first side wall BP1_SW1 in the first extended region AP1_LR may be spaced from the first side wall BP1_SW1 in the first reduced region AP1_SR in the second direction D2 by a first width interval WD11.

In the plan view, the second side wall BP1_SW2 in the first extended region AP1_LR may be spaced from the second side wall BP1_SW2 in the first reduced region AP1_SR in the second direction D2 by a second width interval WD12.

Although the first width interval WD11 is shown to be equal to the second width interval WD12, the disclosure is not limited thereto. The first width interval WD11 may be not equal to the second width interval WD12, according to an embodiment.

The first horizontal side wall 150A_LSW1 of the first source/drain pattern 150A may be symmetrical with the second horizontal side wall 150A_LSW2 of the first source/drain pattern 150A. Unlike the shown example, the first horizontal side wall 150A_LSW1 of the first source/drain pattern 150A may be asymmetric with the second horizontal side wall 150A_LSW2 of the first source/drain pattern 150A, according to an embodiment.

A distance L21 from the first interface 150A_F1 of the first source/drain pattern 150A to the second horizontal intersection 150A_LFC2 may be greater than a distance L22 from the second interface 150A_F2 of the first source/drain pattern 150A to the second horizontal intersection 150A_LFC2.

Alternatively, a distance L21_S from the outer side wall 140OS of the first gate spacer 140 that contacts the second sheet pattern NS12 to the second horizontal intersection 150A_LFC2 may be greater than a distance L22_S from the outer side wall 140OS of the first gate spacer 140 that contacts the third sheet pattern NS13 to the second horizontal intersection 150A_LFC2.

A distance L11 from the first interface 150A_F1 of the first source/drain pattern 150A to the first horizontal intersection 150A_LFC1 may be equal to the distance L21 from the first interface 150A_F1 of the first source/drain pattern 150A to the second horizontal intersection 150A_LFC2.

Unlike the shown example, the distance L11 from the first interface 150A_F1 of the first source/drain pattern 150A to the first horizontal intersection 150A_LFC1 may be different from the distance L21 from the first interface 150A_F1 of the first source/drain pattern 150A to the second horizontal intersection 150A _LFC2. The positions of the first horizontal intersection 150A_LFC1 and the second horizontal intersection 150A_LFC2 may vary, depending on the first width interval WD11 and the second width interval WD12.

The first end point extension line 150A_EX1 does not pass through the first end point 150A_P21 of the second interface 150A_F2. The second end point extension line 150A_EX2 does not pass through the second end point 150A_P22 of the second interface 150A_F2.

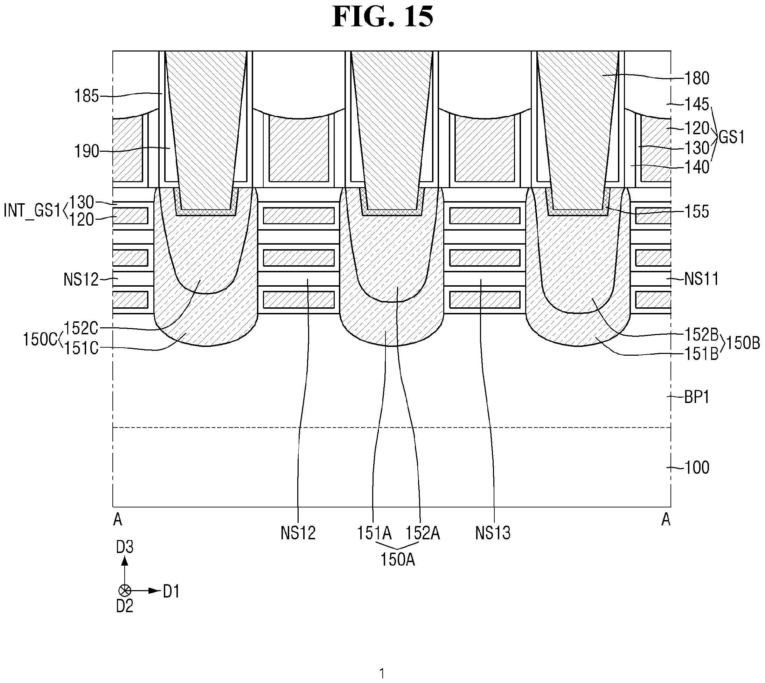

FIG. 15 is a diagram for explaining a semiconductor device according to some embodiments. For convenience of explanation, the explanation will focus on points that are different from those explained using FIGS. 1 to 11.

Referring to FIG. 15, in the semiconductor device according to some embodiments, the source/drain patterns 150A, 150B, and 150C may each not include the width extended region.

The widths of the source/drain patterns 150A, 150B, and 150C in the first direction D1 may increase and then decrease, as they go away from the first lower pattern BP1.

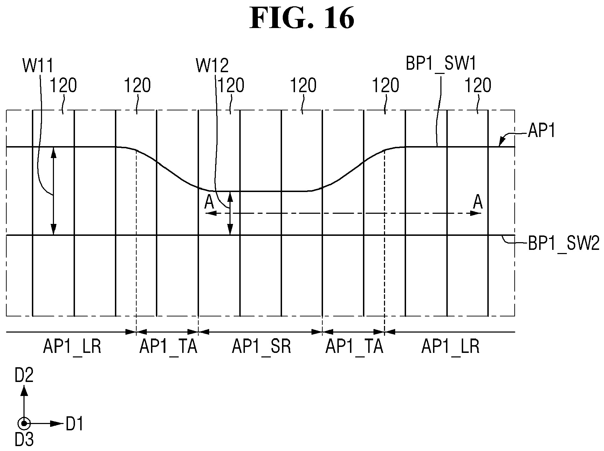

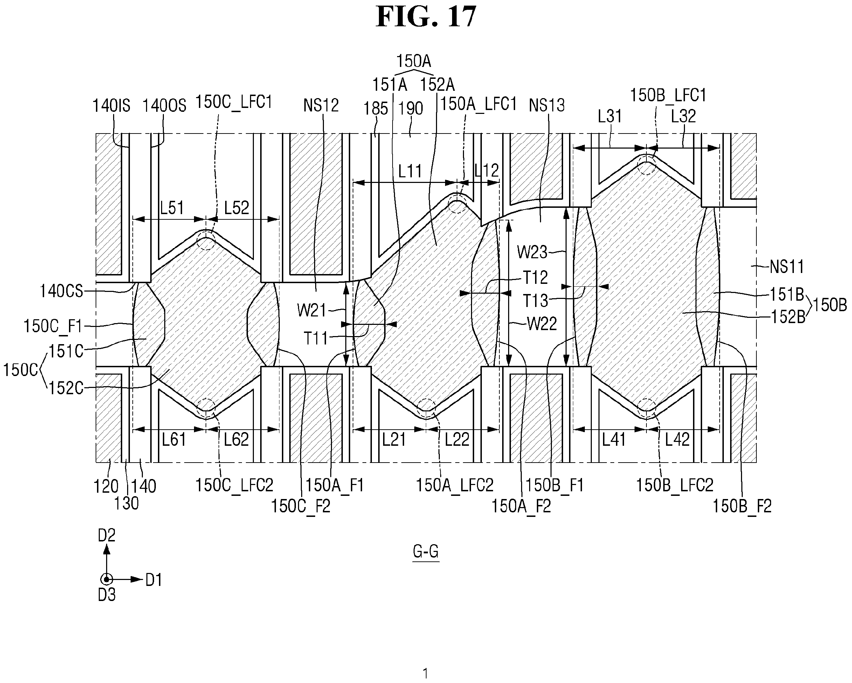

FIGS. 16 and 17 are diagrams for explaining a semiconductor device according to some embodiments. For convenience of explanation, the explanation will focus on points that are different from those explained using FIGS. 1 to 11.

For reference, FIG. 16 is a layout diagram for explaining a semiconductor device according to some embodiments. FIG. 17 may be a plan view of the first active pattern AP1 of FIG. 16 that is taken at a specific height and viewed from above. In other words, the cross-sectional view taken along A-A of FIG. 16 may be the same as FIG. 2. FIG. 17 may be a plan view taken along G-G of FIG. 2 and viewed above.

Referring to FIGS. 16 and 17, in the semiconductor device according to some embodiments, an interface between the first side wall BP1_SW1 in the first extended region AP1_LR and the first side wall BP_SW1 in the first tapered region AP1_TA may have a rounded shape.

An interface between the first side wall BP1_SW1 in the first reduced region AP1_SR and the first side wall BP_SW1 in the first tapered region AP1_TA may have a rounded shape.

The third sheet pattern NS13 may include third and fourth side walls opposite to each other in the second direction D2. The third side wall of the third sheet pattern NS13 may correspond to the first side wall BP1_SW1 of the first lower pattern BP1, and the fourth side wall of the third sheet pattern NS13 may correspond to the second side wall BP1_SW2 of the first lower pattern BP1. That is, the third side wall of the third sheet pattern NS13 is closer to the first horizontal intersection 150A_LFC1 than the fourth side wall of the third sheet pattern NS13.

An interface between the first side wall BP1_SW1 in the first extended region AP1_LR and the first side wall BP_SW1 in the first tapered region AP1_TA may have a rounded shape, and thus, the third side wall of the third sheet pattern NS13 may have a rounded shape, in a plan view. Unlike the third side wall of the third sheet pattern NS13, the fourth side wall of the third sheet pattern NS13 may have a straight line shape.

The second sheet pattern NS12 that may contact the first source/drain pattern 150A may include third and fourth side walls opposite to each other in the second direction D2. The third side wall of the second sheet pattern NS12 may correspond to the first side wall BP1_SW1 of the first lower pattern BP1, and the fourth side wall of the second sheet pattern NS12 may correspond to the second side wall BP1_SW2 of the first lower pattern BP1.

In a plan view, the connection side wall 140CS of the first gate spacer 140 that contacts the third side wall of the second sheet pattern NS12 and the first source/drain pattern 150A may have a rounded shape. Meanwhile, the connection side wall 140CS of the first gate spacer 140 that may contact the fourth side wall of the second sheet pattern NS12 and the first source/drain pattern 150A may have a straight line shape.

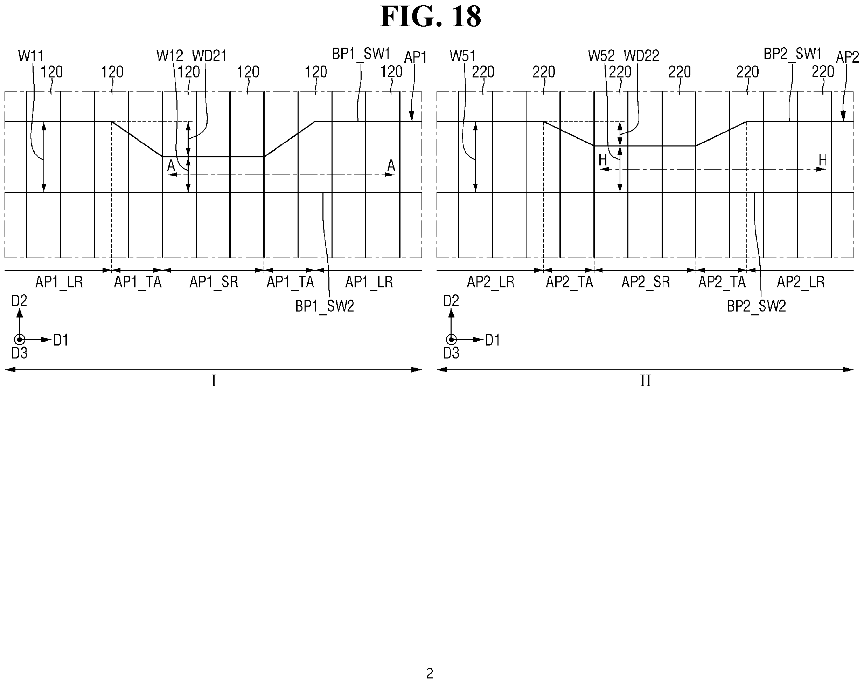

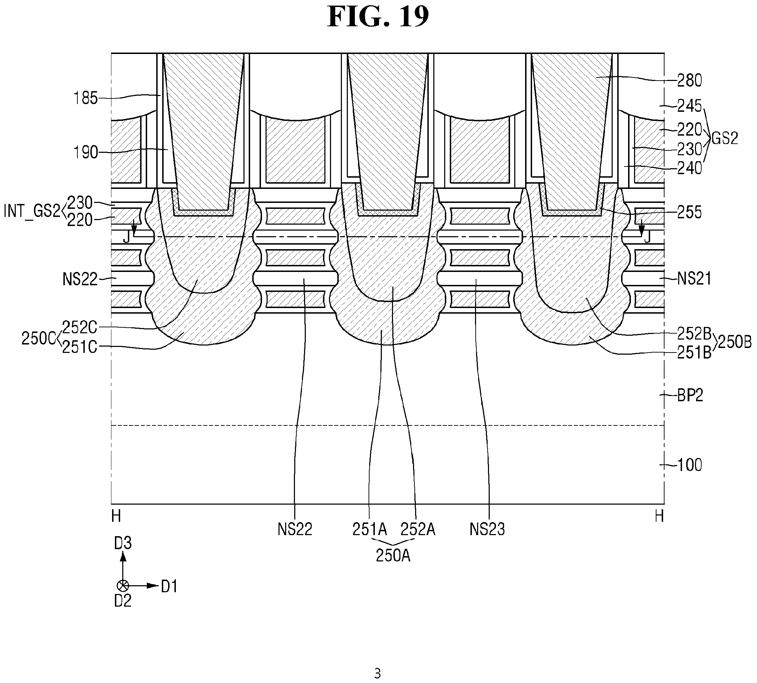

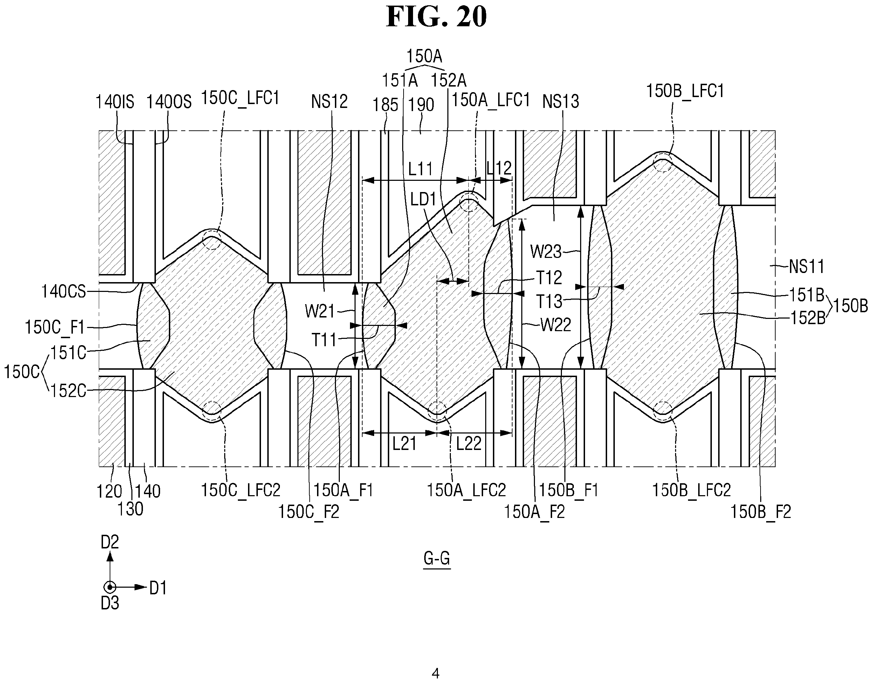

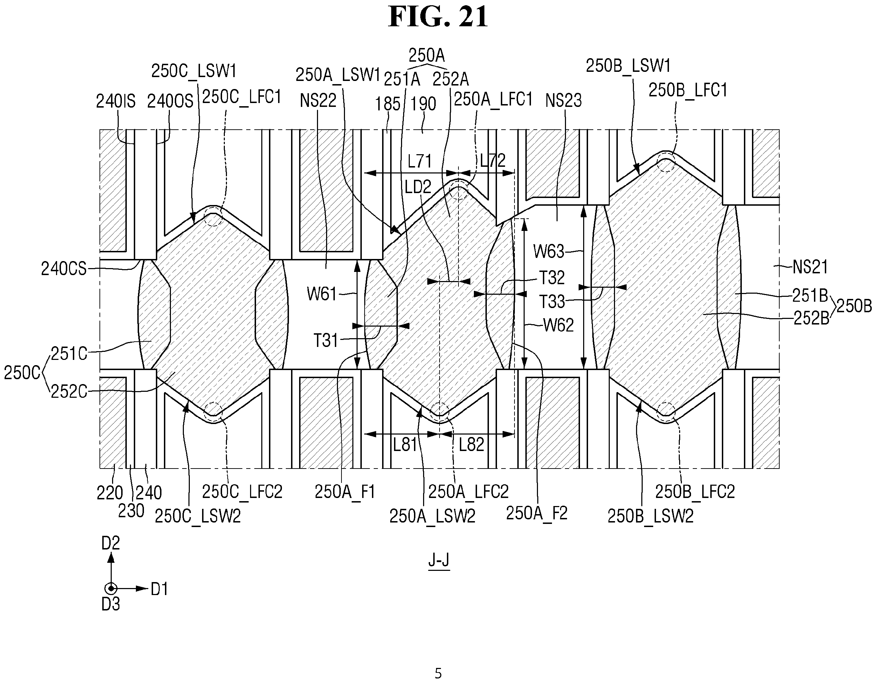

FIG. 18 is a layout diagram for explaining a semiconductor device according to some embodiments. FIG. 19 is an example cross-sectional view taken along H-H of FIG. 18. FIG. 20 is a plan view taken along G-G of FIG. 2 and viewed from above. FIG. 21 is a plan view taken along J-J of FIG. 19 and viewed from above.

A cross-sectional view taken along A-A of FIG. 18 may be the same as FIG. 2. A description of a first region I of FIG. 18 may be substantially the same as that described using FIGS. 1 to 11. Therefore, a following description will focus on a second region II of FIG. 18.

Referring to FIGS. 18 to 21, the semiconductor device according to some embodiments may include a first active pattern AP1, a second active pattern AP2, a plurality of first gate electrodes 120, a plurality of second gate electrodes 220, a first source/drain pattern 150A, a second source/drain pattern 150B, a third source/drain pattern 150C, a fourth source/drain pattern 250A, a fifth source/drain pattern 250B, and a sixth source/drain pattern 250C.

The substrate 100 may include the first region I and the second region II. The first region I and the second region II may be regions in which one or more PMOSs are formed.

The first active pattern AP1, the plurality of first gate electrodes 120, the first source/drain pattern 150A, the second source/drain pattern 150B, and the third source/drain pattern 150C may be disposed in the first region I of the substrate 100. The second active pattern AP2, the plurality of second gate electrodes 220, the fourth source/drain pattern 250A, the fifth source/drain pattern 250B, and the sixth source/drain pattern 250C may be disposed in the second region II of the same substrate 100.

The first active pattern AP1 and the second active pattern AP2 may be parallel with each other, and may be spaced apart from each other in the second direction, according to an embodiment. However, the disclosure is not limited thereto, and the two active patterns AP1 and AP2 may be aligned or connected to each other in the first direction D1, according to an embodiment.

The second active pattern AP2 may be disposed on the substrate 100. The second active pattern AP2 may extend long in the first direction D1. The second active pattern AP2 may include a second extended region AP2_LR, a second reduced region AP2_SR, and a second tapered region AP1_TA. The second tapered region AP2_TA may be disposed between the second extended region AP2_LR and the second reduced region AP2_SR. For example, a width W51 of the second extended region AP2_LR may be greater than a width W52 of the second reduced region AP2_SR.

A first side wall of the second active pattern AP2 may be a first side wall BP2_SW1 of a second lower pattern BP2. A second side wall of the second active pattern AP2 may be a second side wall BP2_SW2 of the second lower pattern BP2. In a plan view, the first side wall BP2_SW 1 of the second lower pattern BP2 may extend in the first direction D1 and have an uneven shape. The second side wall BP2_SW2 of the second lower pattern BP2 may extend in the first direction D1 and have a straight line shape.

In a plan view, the first side wall BP1_SW1 in the first extended region AP1_LR may be spaced apart from the first side wall BP1_SW1 in the first reduced region AP1_SR in the second direction D2 by a third width interval WD21. The first side wall

BP2_SW1 in the second extended region AP2_LR may be spaced apart from the second side wall BP2_SW1 in the second reduced region AP2_SR in the second direction D2 by a fourth width interval WD22. The third width interval WD21 may be different from the fourth width interval WD22.

The second active pattern AP2 may include the second lower pattern BP2, at least one set of fourth sheet patterns NS21, at least one set of fifth sheet patterns NS22, and at least one set of sixth sheet patterns NS23.

The second lower pattern BP2 may protrude from the substrate 100. The second lower pattern BP2 may extend long in the first direction D1. The fourth sheet patterns NS21 may be disposed in the second extended region AP2_LR. The fifth sheet patterns NS22 may be disposed in the second reduced region AP2_SR. The sixth sheet patterns NS23 may be disposed at a boundary portion between the second extended region AP2_LR and the second tapered region AP2_TA. Although not shown, another set of sixth sheet patterns NS23 may be disposed at a boundary portion between the second reduced region AP2_SR and the second tapered region AP2_TA.

Although three fourth sheet patterns NS21, three fifth sheet patterns NS22, and three sixth sheet patterns NS23 are shown as being disposed in the third direction D3, this is only for convenience of explanation, and the number of each of the sets of the first to third sheet patterns NS11, NS12 and NS13 is not limited thereto, and may be more or less than three.

The second lower pattern BP2 and the sheet patterns NS21, NS22, and NS23 may each include one of silicon or germanium that is an elemental semiconductor material, a group IV-IV compound semiconductor or a group III-V compound semiconductor. In the semiconductor device according to some embodiments, the second lower pattern BP2 may be a silicon lower pattern including silicon, and the sheet patterns NS21, NS22, and NS23 may be silicon sheet patterns including silicon.

A plurality of second gate structures GS2 may be disposed on the substrate 100. The second gate structure GS2 may be disposed on the second active pattern AP2. The second gate structure GS2 may intersect the second lower pattern BP2. The second gate structure GS2 may surround the sheet patterns NS21, NS22 and NS23.

The second gate structure GS2 may include a second gate electrode 220, a second gate insulating film 230, a second gate spacer 240, and a second gate capping pattern 245. The second gate structure GS2 may include a second inner gate structure INT_GS2. The second gate spacer 240 may include an inner side wall 240IS, a connection side wall 240CS, and an outer side wall 240OS. Since the description of the second gate structure GS2 is substantially the same as the description of the first gate structure GS1, it will not be provided below.

The fourth source/drain pattern 250A, the fifth source/drain pattern 250B and the sixth source/drain pattern 250C may be disposed on the second active pattern AP2.

The fourth source/drain pattern 250A may be disposed on the second lower pattern BP2 of the second tapered region AP2_TA. The fourth source/drain pattern 250A may be connected to the fifth sheet pattern NS22 and the sixth sheet pattern NS23 adjacent to each other in the first direction D1. The fourth source/drain pattern 250A may contact the fifth sheet patterns NS22 and the sixth sheet patterns NS23.

The fifth source/drain pattern 250B may be disposed on the second lower pattern BP2 of the second extended region AP2_LR. The fifth source/drain pattern 250B may contact the fourth sheet patterns NS21 and the sixth sheet patterns NS23 adjacent to each other in the first direction D1. The sixth source/drain pattern 250C may be disposed on the second lower pattern BP2 of the second reduced region AP2_SR. The sixth source/drain pattern 250C may be disposed between the fifth sheet patterns NS22 adjacent to each other in the first direction D1, and may contact the fifth sheet patterns NS22 adjacent to each other in the first direction D1.

The fourth source/drain pattern 250A, the fifth source/drain pattern 250B, and the sixth source/drain pattern 250C may contact the second gate insulating film 230 included in the second inner gate structure INT_GS2.

The fourth source/drain pattern 250A may include a fourth semiconductor liner film 251A and a fourth semiconductor filling film 252A. The fifth source/drain pattern 250B may include a fifth semiconductor liner film 251B and a fifth semiconductor filling film 252B. The sixth source/drain pattern 250C may include a sixth semiconductor liner film 251C and a sixth semiconductor filling film 252C. Each of the semiconductor liner films 251A, 251B, and 251C may include a silicon-germanium film. Each of the semiconductor filling films 252A, 252B, and 252C may include a silicon-germanium film. A germanium fraction of the semiconductor filling films 252A, 252B, and 252C may be greater than the germanium fraction of the semiconductor liner films 251A, 251B, and 251C. The semiconductor liner films 252A, 252B, and 252C and the semiconductor filling films 252A, 252B, and 252C may include doped p-type impurities.

Shapes of the source/drain patterns 250A, 250B, and 250C will be described below in reference to FIGS. 19 and 21.

The fourth source/drain pattern 250A may include a first interface 250A_F1 that contacts the fifth sheet patterns NS22, and a second interface 250A_F2 that contacts the sixth sheet patterns NS23. The first interface 250A_F1 of the fourth source/drain pattern 250A and the second interface 250A_F2 of the fourth source/drain pattern 250A may be defined by the fourth semiconductor liner film 251A. A width W61 of the first interface 250A_F1 of the fourth source/drain pattern 250A in the second direction D2 may be smaller than a width W62 of the second interface 250A_F2 of the fourth source/drain pattern 250A in the second direction D2.

The fourth source/drain pattern 250A may include a first horizontal side wall 250A_LSW1 and a second horizontal side wall 250A_LSW2 that are opposite to each other in the second direction D2. The first horizontal side wall 250A_LSW1 of the fourth source/drain pattern 250A may include a seventh horizontal intersection 250A _LFC1. The second horizontal side wall 250A_LSW2 of the fourth source/drain pattern 250A may include an eighth horizontal intersection 250A_LFC2.

The first horizontal side wall 250A_LSW1 of the fourth source/drain pattern 250A may be asymmetric with the second horizontal side wall 250A_LSW2 of the fourth source/drain pattern 250A.

A distance L71 from the first interface 250A_F1 of the fourth source/drain pattern 250A to the seventh horizontal intersection 250A_LFC1 may be greater than a distance L72 from the second interface 250A_F2 of the fourth source/drain pattern 250A to the seventh horizontal intersection 250A_LFC1.

A distance L81 from the first interface 250A_F1 of the fourth source/drain pattern 250A to the eighth horizontal intersection 250A_LFC2 may be equal to a distance L82 from the second interface 250A_F2 of the fourth source/drain pattern 250A to the eighth horizontal intersection 250A_LFC2.

The distance L71 from the first interface 250A_F1 of the fourth source/drain pattern 250A to the seventh horizontal intersection 250A_LFC1 may be greater than the distance L81 from the first interface 250A_F1 of the fourth source/drain pattern 250A to the eighth horizontal intersection 250A _LFC2. The distance L72 from the second interface 250A_F2 of the fourth source/drain pattern 250A to the seventh horizontal intersection 250A_LFC1 may be smaller than the distance L82 from the second interface 250A_F2 of the fourth source/drain pattern 250A to the eighth horizontal intersection 250A _LFC2. Here, the distances L71, L72, L81 and L82 may all be horizontal distances measured in the first direction D1.

In the fourth source/drain pattern 250A, the seventh horizontal intersection 250A_LFC1 may be spaced apart from the eighth horizontal intersection 250A_LFC2 in the first direction D1 by a second tip interval LD2.

In the first source/drain pattern 150A of FIG. 20, the first horizontal intersection 150A_LFC1 may be spaced apart from the second horizontal intersection 150A_LFC2 in the first direction D1 by a first tip interval LD1.

The first tip interval LD1 may be different from the second tip interval LD2. A difference between the first tip interval LD1 and the second tip interval LD2 may be due to a difference between the third width interval WD21 and the fourth width interval WD22.

The third width interval WD21 may affect the first tip interval LD1. The fourth width interval WD22 may affect the second tip interval LD2. For example, when the third width interval WD21 increases, the first tip interval LD1 may also increase. As the difference between the third width interval WD21 and the fourth width interval WD22 increases, the difference between the first tip interval LD1 and the second tip interval LD2 may also increase.

The fifth source/drain pattern 250B may include a first horizontal side wall 250B_LSW1 and a second horizontal side wall 250B_LSW2 that are opposite to each other in the second direction D2. The first horizontal side wall 250B_LSW1 of the fifth source/drain pattern 250B may include a ninth horizontal intersection 250B_LFC1. The second horizontal side wall 250B_LSW2 of the fifth source/drain pattern 250B may include a tenth horizontal intersection 250B_LFC2.

The sixth source/drain pattern 250C may include a first horizontal side wall 250C_LSW1 and a second horizontal side wall 250C_LSW2 that are opposite to each other in the second direction D2. The first horizontal side wall 250C_LSW1 of the sixth source/drain pattern 250C may include an eleventh horizontal intersection 250C _LFC1. The second horizontal side wall 250C_LSW2 of the sixth source/drain pattern 250C may include a twelfth horizontal intersection 250C_LFC2.

The first horizontal side wall 250B_LSW1 of the fifth source/drain pattern 250B may be symmetrical with the second horizontal side wall 250B_LSW2 of the fifth source/drain pattern 250B. The first horizontal side wall 250C_LSW1 of the sixth source/drain pattern 250C may be symmetrical with the second horizontal side wall 250C_LSW2 of the sixth source/drain pattern 250C.

Since a description of the fifth source/drain pattern 250B and the sixth source/drain pattern 250C may be substantially the same as the description of the second source/drain pattern 150B and the third source/drain pattern 150C, it will not be described below.

In a plan view, a width W61 of the fourth semiconductor liner film 251A that contacts the fifth sheet patterns N22 may be smaller than a width W62 of the fourth semiconductor liner film 251A that contacts the sixth sheet patterns N23. A width W63 of the fifth semiconductor liner film 251B that contacts the sixth sheet patterns NS23 may be greater than a width W62 of the fourth semiconductor liner film 251A that contacts the sixth sheet patterns N23.

A thickness T31 of the fourth semiconductor liner film 251A that contacts the fifth sheet patterns N22 may be greater than a thickness T32 of the fourth semiconductor liner film 251A that contacts the sixth sheet patterns N23. A thickness T33 of the fifth semiconductor liner film 251B that contacts the sixth sheet patterns NS23 may be smaller than a thickness T32 of the fourth semiconductor liner film 251A that contacts the sixth sheet patterns N23.

A second source/drain contact plug 280 may be disposed on each of the source/drain patterns 250A, 250B, and 250C. The second source/drain contact plug 280 may be connected to each of the source/drain patterns 250A, 250B and 250C. The second source/drain contact plug 280 may pass through the interlayer insulating layer 190 and the source/drain etching stop film 185, and may be connected to each of the source/drain patterns 250A, 250B and 250C.

A second contact silicide film 255 may be further disposed between the second source/drain contact plug 280 and each of the source/drain patterns 250A, 250B, and 250C.

Although the second source/drain contact plug 280 is shown to be a single film, this is only for convenience of explanation, and the disclosure is not limited thereto. The second source/drain contact plug 280 may include, for example, at least one of metal, metal alloy, conductive metal nitride, conductive metal carbide, conductive metal oxide, conductive metal carbonitride, and two-dimensional material (2D material).

The second contact silicide film 255 may include metal silicide.

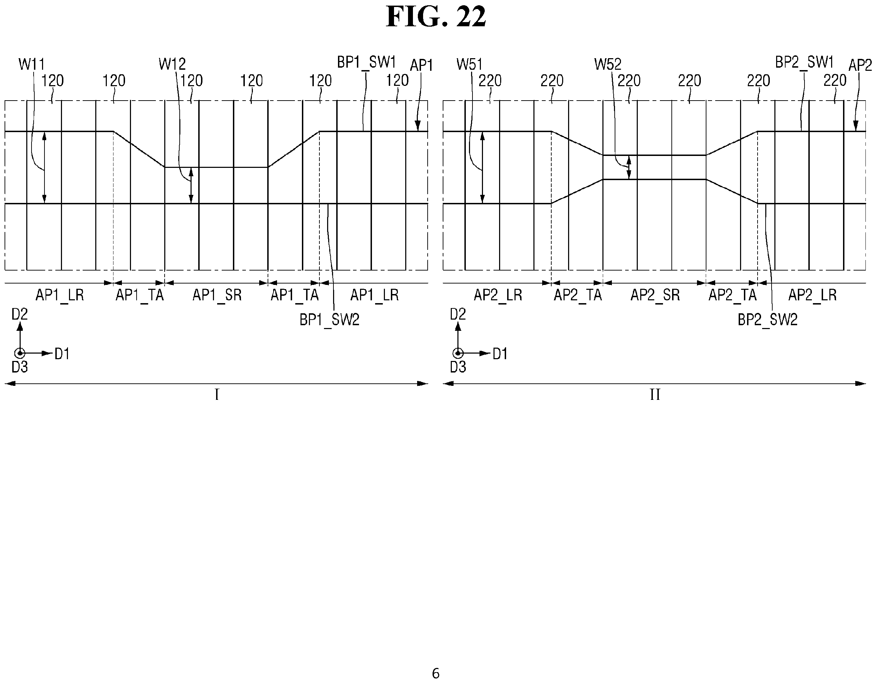

FIG. 22 is a layout diagram for explaining a semiconductor device according to some embodiments. For convenience of explanation, the explanation will focus on points that are different from those explained using FIGS. 18 to 21.

For reference, when a second region II of FIG. 22 is cut at a certain height and viewed from above, a plan view may be similar to FIG. 13.

Referring to FIG. 22, in the semiconductor device according to some embodiments, a first side wall BP2_SW1 of the second lower pattern BP2 and a second side wall BP2_SW2 of the second lower pattern BP2 may extend in the first direction D1 in a plan view, and may have an uneven shape.

The first side wall BP2_SW1 in the second extended region AP2_LR may be not linearly aligned with the first side wall BP2_SW 1 in the second reduced region AP2_SR along the first direction D1.

The second side wall BP2_SW2 in the second extended region AP2 _LR may be not linearly aligned with the second side wall BP2_SW2 in the second reduced region AP2_SR along the first direction D1.

In the above embodiments, a plurality of source/drain patterns having different dimensions connected to the same sheet patterns, that is, a channel structure, may be formed on a same active pattern extended in the first direction D1, and on different active patterns on a same substrate. Thus, a semiconductor device or field-effect transistor (e.g., a nanosheet transistor) formed of source/drain patterns having different characteristics may be obtained to address demands for a plurality of different high performance/low power-consumption devices for memory circuits, logic circuits, etc.

In the above embodiments, various semiconductor devices are formed of a plurality of sets of sheet patterns, that is, nanosheet layers, as channel structures forming respective nanosheet transistors based on the differently-sized source/drain regions. However, the disclosure is not limited to only nanosheet transistors, and may also apply to different types of field-effect transistor such as FinFET. Thus, the plurality of sheet patterns described above and illustrated in the drawings may be replaced by fin structures forming respective FinFETs.

In concluding the detailed description, those skilled in the art will appreciate that many variations and modifications may be made to the above-described embodiments without substantially departing from the principle of the present disclosure. Therefore, the above embodiments are used in a generic and descriptive sense only and not for purposes of limitation.

## Claims

1. A semiconductor device comprising:
a first channel structure and a second channel structure spaced apart from each other in a first direction; and
a source/drain pattern, between the first channel structure and the second channel structure, comprising a first interface contacting the first channel structure and a second interface contacting the second channel structure,
wherein, in a plan view, the source/drain pattern comprises a first side wall and a second side wall opposite to each other in a second direction,
wherein the first side wall of the source/drain pattern comprises a first sloped side wall, a second sloped side wall, and a first horizontal intersection at which the first sloped side wall and the second sloped side wall meet,
wherein a width of the first interface is different from a width of the second interface, in the second direction, and
wherein a distance from the first interface to the first horizontal intersection is greater than a distance from the second interface to the first horizontal intersection, in the first direction.

2. The semiconductor device of claim 1, wherein the width of the first interface is smaller than the width of the second interface, in the second direction.

3. The semiconductor device of claim 1 or 2, wherein each of the first and second interfaces comprises first and second end points spaced apart from each other in the second direction,
wherein the first end point of the first interface is closer to the first side wall of the source/drain pattern than the second end point of the first interface,
wherein the first end point of the second interface is closer to the first side wall of the source/drain pattern than the second end point of the second interface, and
wherein an end point extension line passing through the first end point of the first interface and extending in the first direction does not pass through the first end point of the second interface.

4. The semiconductor device of claim 1 or 2, wherein, in the plan view, the second side wall of the source/drain pattern has a third sloped side wall, a fourth sloped side wall, and a second horizontal intersection at which the third sloped side wall and the fourth sloped side wall meet, and
wherein a distance from the first channel structure to the second horizontal intersection is equal to a distance from the second channel structure to the second horizontal intersection.

5. The semiconductor device of claim 4, wherein each of the first and second interfaces comprises first and second end points spaced apart from each other in the second direction,
wherein the first end point of the first interface is closer to the first side wall of the source/drain pattern than the second end point of the first interface,
wherein the first end point of the second interface is closer to the first side wall of the source/drain pattern than the second end point of the second interface,
wherein a first end point extension line passing through the first end point of the first interface and extending in the first direction does not pass through the first end point of the second interface, and
wherein a second end point extension line passing through the second end point of the first interface and extending in the first direction passes through the second end point of the second interface.

6. The semiconductor device of claim 1, wherein the second side wall of the source/drain pattern comprises a third sloped side wall, a fourth sloped side wall, and a second horizontal intersection at which the third sloped side wall and the fourth sloped side wall meet, and
wherein a distance from the first channel structure to the second horizontal intersection is greater than a distance from the second channel structure to the second horizontal intersection.

7. The semiconductor device of claim 6, wherein each of the first and second interfaces comprises first and second end points spaced apart in the second direction,
wherein the first end point of the first interface is closer to the first side wall of the source/drain pattern than the second end point of the first interface,
wherein the first end point of the second interface is closer to the first side wall of the source/drain pattern than the second end point of the second interface,
wherein a first end point extension line passing through the first end point of the first interface and extending in the first direction does not pass through the first end point of the second interface, and
wherein a second end point extension line passing through the second end point of the first interface and extending in the first direction does not pass through the second end point of the second interface.

8. The semiconductor device of any preceding claim, wherein the source/drain pattern comprises a semiconductor liner film, contacting the first channel structure and the second channel structure, and a semiconductor filling film on the semiconductor liner film,
wherein, in the plan view, the semiconductor liner film comprises a first sub-liner film, contacting the first channel structure, and a second sub-liner film contacting the second channel structure,
wherein the semiconductor filling film is disposed between the first sub-liner film and the second sub-liner film, and
wherein a width of the first sub-liner film is smaller than a width of the second sub-liner film, in the second direction.

9. The semiconductor device of claim 8, wherein a thickness of the first sub-liner film is different from a thickness of the second sub-liner film, in the first direction.

10. The semiconductor device of claim 8 or 9, wherein each of the first sub-liner film and the second sub-liner film comprises an inner side surface facing the semiconductor filling film,
wherein the inner side surface of the first sub-liner film comprises a first facet portion and a first connecting portion connected to the first facet portion and extending in the second direction,
wherein the inner side surface of the second sub-liner film comprises a second facet portion and a second connecting portion connected to the second facet portion and extending in the second direction, and
wherein a width of the first connecting portion is different from a width of the second connecting portion, in the second direction.

11. The semiconductor device of any preceding claim, wherein each of the first channel structure and the second channel structure comprises a plurality of sheet patterns vertically arranged on a substrate.

12. A semiconductor device comprising:
a first channel structure and a second channel structure spaced apart from each other in a first direction; and
a source/drain pattern, between the first channel structure and the second channel structure, comprising a first interface contacting the first channel structure and a second interface contacting the second channel structure,
wherein, in a plan view, the source/drain pattern comprises a first side wall and a second side wall opposite to each other in a second direction,
wherein the first side wall of the source/drain pattern comprises a first sloped side wall, a second sloped side wall, and a first horizontal intersection at which the first sloped side wall and the second sloped side wall meet,
wherein the second side wall of the source/drain pattern comprises a third sloped side wall, a fourth sloped side wall, and a second horizontal intersection at which the third sloped side wall and the fourth sloped side wall meet,
wherein a width of the first interface is smaller than a width of the second interface, in the second direction, and
wherein a distance from the first interface to the first horizontal intersection is different from a distance from the first interface to the second horizontal intersection, in the first direction.

13. The semiconductor device of claim 12, wherein the distance from the first interface to the first horizontal intersection is greater than the distance from the first interface to the second horizontal intersection, and
wherein the distance from the first channel structure to the second horizontal intersection is equal to the distance from the second channel structure to the second horizontal intersection.

14. The semiconductor device of claim 12 or 13, wherein each of the first and second interfaces comprises first and second end points spaced apart in the second direction,
wherein the first end point of the first interface is closer to the first side wall of the source/drain pattern than the second end point of the first interface,
wherein the first end point of the second interface is closer to the first side wall of the source/drain pattern than the second end point of the second interface,
wherein a first end point extension line passing through the first end point of the first interface and extending in the first direction does not pass through the first end point of the second interface, and
wherein a second end point extension line passing through the second end point of the first interface and extending in the first direction passes through the second end point of the second interface.

15. The semiconductor device of claim 12, 13 or 14, wherein the source/drain pattern comprises a semiconductor liner film, contacting the first channel structure and the second channel structure, and a semiconductor filling film on the semiconductor liner film,
wherein, in the plan view, the semiconductor liner film comprises a first sub-liner film, contacting the first channel structure, and a second sub-liner film contacting the second channel structure,
wherein the semiconductor filling film is disposed between the first sub-liner film and the second sub-liner film, and
wherein a thickness of the first sub-liner film is greater than a thickness of the second sub-liner film, in the first direction.
